# EUROPEAN PATENT SPECIFICATION

(11) **EP 0 709 483 B1**
(45) Date of publication and mention of the grant of the patent: **10.04.2002**
(21) Application number: 95116913.5
(22) Date of filing: 26.10.1995
(51) Int. Cl.: C23C 14/02, C23C 14/06, C23C 28/04, C23C 30/00, C23C 16/02, C23C 16/34, C23C 16/36

(54) **Multilayer material**
Mehrschichtiges Material
Matériau multicouche

(30) Priority: 28.10.1994 JP 28902294; 28.10.1994 JP 28902394
(43) Date of publication of application: 01.05.1996
(73) Proprietor: SUMITOMO ELECTRIC INDUSTRIES, LTD., Osaka-shi, Osaka 541 (JP)
(72) Inventor: Setoyama, Makoto, c/o Itami Works Sumitomo Elec., Itami-shi, Hyogo 664 (JP); Yoshioka, Takashi, c/o Itami Works Sumitomo Elec., Itami-shi, Hyogo 664 (JP); Chudo, Masuo, c/o Itami Works Sumitomo Elec., Itami-shi, Hyogo 664 (JP); Shibata, Akihiko, c/o Itami Works Sumitomo Elec., Itami-shi, Hyogo 664 (JP)
(74) Representative: Herrmann-Trentepohl, Werner, Dipl.-Ing.

(56) References cited:
- EP-A- 0 448 720
- EP-A- 0 594 875
- EP-A- 0 685 572
- EP-A- 0 701 982
- US-A- 4 686 156
- ENGINEERS' DIGEST, vol. 38, no. 8, 1 August 1977, page 51,53,56 XP002026196 W. SCHEDLER: "Coated hardmetals in the machine shop"

## Description

### BACKGROUND OF THE INVENTION

### Field of the Invention

The present invention relates to a thin-film multilayer material, more specifically to a thin-film multilayer material which is useful as a surface coating material to be disposed for the purpose of improving wear-resistance, etc., and as a surface coating material for a hard metal such as cutting tool and wear-resistant tool, or a surface coating material for an electric or electronic component (or part), a sliding or mechanical component, etc.

### Related Background Art

Heretofore, in the field of a cutting tool, it has been practiced that a coating of one layer or multilayer (composite layer) comprising a carbide, nitride or carbonitride (or carbide/nitride) of Ti, Hf, or Zr, or an oxide of Al is disposed on a surface of a base material comprising a hard metal (such as cemented carbide), etc., by using PVD (physical vapor deposition) or CVD (chemical vapor deposition) for the purpose of improving the wear resistance of the cutting tool.

Particularly, the coating formed by the above PVD method has an advantage such that the wear resistance of the resultant product may easily be improved without lowering the strength of the base material. Accordingly, such a surface coating has widely been used in the field of a cutting tool which is particularly required to have an excellent strength, such as throw-away type tip (or replaceable-type tip) to be used for a drill, an end mill, and an milling cutter.

However, the material of the surface coating layer (nitride or carbonitride) currently used has a problem such that it does not have a sufficient resistance to wear and heat, and particularly in the field of a tool for high-speed cutting, the life of the tool is shortened.

Under these circumstances, Japanese Laid-Open Patent Application (KOKAI) No. Sho 61-235555 (i.e., 235555/1986) by H. Holleck et al. corresponding to German Patent Application (DE No. 3512986) describes a multilayer film which has a structure comprising two kinds of ceramic thin film of TiC and TiB₂ having a metallic bonding property with a film thickness of 40 nm or less, between which a total number of 100 - 20000 (in the entirety of the coating film) of "coherent or partially coherent interfaces" have been introduced, and which has been prepared by a sputtering method using targets of TiC and TiB₂.

However, according to the present invention's investigation, it has been found that the hardness (i.e., one of the indications of wear resistance) of the above conventional multilayer film is not necessarily sufficient.

EP 0701982 A1 (representing a document falling within the terms of Article 54(3)EPC) discloses a multilayer material wherein each layer is formed of ultrafine particles consisting mainly of carbide, nitride, carbon nitride and oxide and at least one element selected from a group consisting of IVa group elements, Va group elements, Via group elements in the periodic table of the IUPAC 1970, Al, Si and B.

### Summary of the Invention

An object of the present invention is to provide a multilayer material having a multilayer film structure, which has been improved in an wear resistance.
Another object of the present invention is to provide a multilayer material having a multilayer film structure, which is capable of providing a member of a hard material improved in a cutting performance.
As a result of earnest study of the present inventors, it has been found that the above objects are effectively achieved by forming a multilayer material comprising: a base material which comprises a WC-based hard material, and a multilayer portion which comprises: two kinds of compound layers of TiN and AlN; a composition-modulated layer disposed between the compound layers, and having a composition such that the composition ratio (at%) of an element is changed; the compound layer and the composition-modulated layer being periodically stacked; the multilayer material further comprising an intermediate layer disposed on the base material side of the multilayer portion, the intermediate layer comprising (Ti0.4,Al0.6)N; the intermediate layer, and at least one layer of the multilayer portion nearest to the base material side having a continuous crystal lattice; and the multilayer material further comprising an adhesion layer which is disposed on the base material side surface of the intermediate layer, the adhesion layer comprising TiN.

According to another aspect of the invention, a multilayer material is provided, comprising: a base material which comprises a WC-based hard material, and a multilayer portion which comprises two kinds of compound layers of (Ti0.8,Al0.2)N and HfN; a composition-modulated layer disposed between the compound layers, and having a composition such that the composition ratio (at%) of an element is changed; the compound layer and the composition-modulated layer being periodically stacked; the multilayer material further comprising an intermediate layer disposed on the base material side of the multilayer portion, the intermediate layer comprising NbN; the intermediate layer, and at least one layer of the multilayer portion nearest to the base material side having a continuous crystal lattice; and the multilayer material further comprising an adhesion layer which is disposed on the base material side surface of the intermediate layer, the adhesion layer comprising TiN.

As described above, in the above-mentioned first aspect of the present invention, the multilayer material comprises: at least two kinds of compound layers and a composition-modulated layer disposed between the compound layers and having a composition characteristic such that the composition therein is changed with a predetermined tendency (e.g., with a unidirectional change such as increase and decrease). In other words, the respective layers constituting the conventional multilayer film have "interfaces" (i.e., a boundary at which the composition is discontinuous) therebetween. On the contrary, the multilayer material according to the present invention (at least, in the periodic structure thereof comprising the compound layer and the composition-modulated layer) does not have such an "interface", but the at least two kinds of the compound layers are adjacent to the above "composition-modulated layer" disposed therebetween.

According to the present inventors' knowledge, in the present invention, it is presumed that the crystal lattices are continuous and stabilized while the lattices are somewhat strained and the crystal structure is somewhat changed, whereby strain energy is accumulated in the multilayer film. Further, it is presumed that on the basis of the strain energy thus accumulated in the entire multilayer film, the hardness of the multilayer film is improved and the wear resistance thereof is enhanced (and/or the propagation of a crack is suppressed, and peeling or exfoliation between the respective layers constituting the multilayer material, or between the base material and the multilayer material is suppressed. According to the present inventors' experiments, it has been found that in a case where the above-mentioned composition-modulated layer is provided between the compound layers, good matching may easily be provided.

Further, according to the present inventors' knowledge, it has been found that the multilayer material according to the present invention tends to provide a (stacking) period (a period capable of improving the wear resistance) in a wider range as compared with the conventional multilayer materials. Accordingly, in the multilayer material according to the present invention, it is easy to obtain a higher wear resistance in a wider period as compared with the conventional multilayer materials. In addition, in the present invention, it is easy to decrease the number of layers constituting the multilayer structure capable of providing the same thickness of the multilayer film, or the same wear resistance, as compared with the conventional multilayer materials. Therefore, the multilayer film according to the present invention may be produced more easily than the conventional multilayer materials.

On the contrary, in the above-mentioned multilayer film of Holleck having a large number of "interfaces", it is presumed that the dislocation (misfit dislocation) corresponding to a difference in the lattice constant (misfit) is liable to occur at the interface between the substances having different lattice constants (usually, different substances have different lattice constants, respectively), and therefore the improvement in the hardness (improvement in wear resistance) based on the "matching" is extremely small. In addition, the stress tends to be concentrated on the above interface, and therefore exfoliation (or peeling) is liable to occur at the interface. Further, in this type of the multilayer film, substances having different crystal structures, such as TiC-TiB₂, tend to be partially matched with each other at the interface therebetween, while selecting a certain crystal orientation (e.g., TiC (111) and TiB₂ (0001)), and therefore it is presumed that the crystal structure of one of the above different substances is not changed so that they do not constitute a single crystal structure as a whole.

According to the present inventors' knowledge, it is presumed that in the multilayer material according to the present invention having the above-mentioned structure, the "matching" is stabilized on the basis of the presence of the intermediate layer which has the above specific composition and has a continuous crystal lattice in relation with the lowermost layer of the above multilayer portion (i.e., the layer constituting the multilayer portion disposed nearest to the base material), whereby the wear resistance of the entire multilayer material is improved as a whole. It is presumed that the above stabilization due to the intermediate layer is mainly based on its physical effect.

In addition, in the present invention, the effect of improving the wear resistance based on the stacking may be enhanced by the "flattening" based on the presence of the intermediate layer. Further, the effect of improving the wear resistance based on the stacking may also be enhanced by utilizing an "orientation" effect in the intermediate layer.

In addition, in the present invention the above intermediate layer is in direct contact with the base material, so that it is possible to impart to the intermediate layer a function of causing the multilayer portion to closely contact the base material. It is presumed that such a function of is mainly based on the chemical composition thereof.

Further, due to the composition-modulated layer in the present invention, wherein the composition ratio (at%) of an Element is changed and which is disposed between the adjacent compound layers, the "matching" of the multilayer portion may be further stabilized on the basis of the presence of the composition-modulated layer so as to further improve the wear resistance of the entire multilayer material.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art from this detailed description.

The present invention will be more fully understood from the detailed description given hereinbelow and the accompanying drawings, which are given by way of illustration only and are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention will be apparent to those skilled in the art from this detailed description.

### BRIEF DESCRIPTION OF THE DRAWINGS

Fig. 1 is a graph schematically showing a typical example of thin-film X-ray diffraction pattern.
Fig. 2 is a graph showing a typical example of diffraction pattern of cubic crystal (TiN).
Fig. 3 is a graph showing a typical example of diffraction pattern of cubic crystal (TiN).
Fig. 4 is a graph showing a typical example of diffraction pattern (single pattern)of TiN/AlN modulation film.
Fig. 5 is a graph showing a typical example of diffraction pattern of cubic crystal (ZrN).
Fig. 6 is a graph showing a typical example of diffraction pattern of cubic crystal (TiN).
Fig. 7 is a graph showing a typical example of diffraction pattern (single pattern)of a TiN/ZrN modulation film.
Fig. 8 is a graph showing a typical example of X-ray diffraction pattern (not a single pattern) of TiN/ZrN modulation film.
Fig. 9 is a schematic sectional view showing an embodiment of the multilayer material structure according to the present invention.
Fig. 10 is a schematic sectional view showing an embodiment of the film forming apparatus to be usable for the formation of the multilayer material according to the present invention.
Fig. 11 is a schematic plan view showing an embodiment of the film forming apparatus (wherein an overlapping of plasmas based on different targets is present) to be usable for the formation of the multilayer material according to the present invention.
Fig. 12 is a schematic plan view showing a film forming apparatus used in Examples appearing hereinafter.
Fig. 13 is a schematic plan view showing an embodiment of the film forming apparatus (wherein an overlapping of plasmas based on different targets is not present) used for the formation of a multilayer material having no composition-modulated layer in Comparative Examples appearing hereinafter.
Fig. 14 is a graph showing an example of compositional distribution of the respective substrates (substrate position - Ti/Al composition ratio) which was determined by the composition profile analysis in Examples.

Fig. 15 is a graph showing an example of compositional distribution of the respective substrates (substrate position - film thickness) which was determined by the composition profile analysis in Examples.

Fig. 16 is a graph showing an example of the composition profile (distance in the film thickness direction - Ti/Al composition ratio) corresponding to one period which was determined on the basis of the above results of the analyses of the compositional distribution and film thickness distribution.

Fig. 17 is a graph showing an example of the composition profile (distance in the film thickness direction - Ti/Al composition ratio) corresponding to some periods which was determined on the basis of the above results of the analyses of the compositional distribution and film thickness distribution.

Fig. 18 a graph showing the distribution of Al, Ti and N in the film thickness direction which was determined on the basis of TEM/EDX analysis conducted in Example.

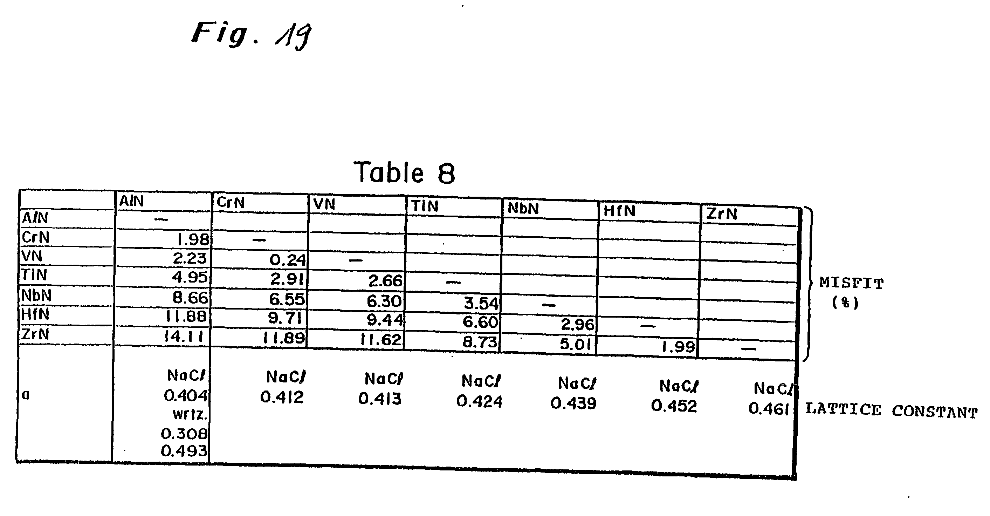

Fig. 19 is a table (Table 8) showing examples of the lattice constant of nitrogen compounds and misfits (%) between the respective nitrogen compounds.

Fig. 20 is a table (Table 9) showing the structures of multilayer materials including a periodic multilayer (wear-resistant layer) prepared in Examples.

Fig. 21 is a table (Table 10) showing the structures of the intermediate layers included in the above multilayer materials.

Fig. 22 is a table (Table 11) showing the structures of the periodic multilayers (multilayer portion) included in the above multilayer materials.

Fig. 23 is a table (Table 12) showing the crystal structures of the multilayer portions included in the above multilayer materials.

Fig. 24 is a table (Table 13) showing the kinds of base materials and the cutting conditions employed in Examples.

Fig. 25 is a table (Table 14) showing the cutting performances of multilayer materials obtained by the evaluation under the cutting conditions as shown in Fig. 24.

Fig. 26 is a photograph (reproduction) showing a TEM image provided by high-magnification TEM analysis (after an ion etching treatment) conducted in Example.

Figs. 27A and 27B are photographs (reproduction) each showing a diffraction pattern provided by TED measurement conducted in Example.

Fig. 28 is a schematic plan view showing a film forming apparatus used for the formation of a multilayer material in Examples.

### DETAILED DESCRIPTION OF PREFERRED EMBODIMENTS

Hereinbelow, the present invention will be described in detail with reference to the accompanying drawings, as desired.

According to an aspect of the present invention, the multilayer material comprises at least two kinds of compound layers, and a composition-modulated layer disposed between the composition layers, an intermediate layer disposed on the base material side of the multilayer portion, and an adhesion layer. Hereinbelow, there are described respective layers and components constituting the multilayer film according to the present invention.

### (Compound layer)

In the present invention, the above-mentioned "compound layer" refers to a layer wherein the composition ratio of the First Element (at %) is substantially constant in the thickness direction thereof (in the present invention, the term "compound" is used so that it includes "solid solution"). The xx"First element" used herein refers to Ti or Al or (Ti0.8, Al0.2) or Hf.

The compound layer is a layer comprising a compound mainly comprising the above First Element and N (hereinafter referred to as "Second Element").

In the above compound layer, the relative range of variation in the composition ratio of the First Element and/or Second Element (at %), i.e., the value of ((maximum value-minimum value)/maximum value) thereof, may preferably be not more than 15 %, more preferably not more than 10 % (particularly preferably, not more than 5 %) with respect to the thickness direction thereof.

For example, the composition ratio of the First Element or Second Element (at %) may be confirmed by means of energy dispersive X-ray analysis (EDX) or electron energy-loss spectroscopy (EELS).

In the above EDX or EELS analysis, for example, the following conditions may preferably be employed.

### <Measurement apparatus>

Measurement apparatus: HB-501 mfd. by VG Co.
EDX: KEVEX Super8000, Total System for Quantitative Analysis
Energy dispersive X-ray analyzer:
   (Si <Li>semiconductor detector, UTW-type)
EELS: ELS-80 Spectrometer mfd. by VG Co.
   (energy resolution: 0.56 eV)

### <Measurement conditions>

Accelerating voltage: 100 kv
Sample absorption current: 10⁻⁹ A
Counting time: 50-100 seconds
Analyzing probe diameter: 1 nm Φ

The above compound layer (one layer) may preferably have a thickness of 100 nm or less, more preferably about 1 - 20 nm (particularly preferably, about 1 - 10 nm). When the thickness is below 1 nm, the effect of provision of the composition-modulated layer is liable to be insufficient. On the other hand, when the thickness exceeds 100 nm (further, exceeds 20 nm), the effect of improving the hardness or wear resistance due to the stacking (or multilayer formation) is liable to be insufficient. For example, the thickness of the compound layer (one layer) may be confirmed by use of a transmission electron microscope (TEM).

In this TEM analysis, for example, the following conditions may preferably be used.

### <Conditions for TEM analysis>

Measurement apparatus: trade name: H-9000UHR, mfd. by Hitachi Seisakusho K.K.
Accelerating voltage: 300 kV
Magnification: 20 × 10⁴ - 800 x 10⁴

### (Composition-modulated layer)

In the present invention, the "composition-modulated layer" refers to a layer wherein the composition ratio (at %) of the First Element and/or the Second Element is changed with a predetermined or definite tendency with respect to the thickness direction thereof (e.g., with a unidirectional change such as increase or decrease with respect to the thickness direction). In the composition-modulated layer, it is sufficient that the composition ratio of at least one of the First Element and the Second Element is changed.

When the compound layers adjacent to the composition-modulated layer are denoted by "Compound Layer A" and "Compound Layer B", respectively, the composition of the composition-modulated layer on the side thereof adjacent to the "Compound Layer A" may preferably be substantially the same as that of the "Compound Layer A". On the other hand, the composition of the composition-modulated layer on the side thereof adjacent to the "Compound Layer B" may preferably be substantially the same as that of the "Compound Layer B". In other words, in such an embodiment, the composition-modulated layer may preferably be a layer having a compositional change such that the composition thereof is changed from the composition which is substantially the same as that of the "Compound Layer A" to the composition which is substantially the same as that of the "Compound Layer B" (or a layer having a reverse compositional change).

In the present invention, the composition-modulated layer (one layer) may preferably have a thickness of 0.4 nm or more, more preferably about 0.4 - 100 nm (particularly preferably about 0.4 - 20 nm). For example, the thickness of the composition-modulated layer (one layer) may be confirmed by the TEM measurement in the same manner as in the measurement of the thickness of above compound layer.

When the thickness of compound layer is denoted by a (nm) and the thickness of the composition-modulated layer is denoted by b (nm), the ratio between these thicknesses (b/a) may preferably be about 1/10 to 10, more preferably about 1/5 to 5, in view of the prevention of the separation between the compound layers or the stabilization of "matching" in the entire multilayer material.

In the present invention, it is preferred that the composition ratio (at %) of the First Element (and/or the Second Element; the same in the following description with respect to the composition-modulated layer) is changed substantially continuously in the thickness direction of the "composition-modulated layer". The term "substantially continuous change" used herein refers to substantial absence of "interface" (i.e., a face or plane at which the composition becomes discontinuous) in the composition-modulated layer. More specifically, when the difference between the composition ratio (at %) of the First Element (Eₐ) constituting the "Compound Layer A" and the First Element (Eₐ) constituting the "Compound Layer B" is denoted by |Eₐ₂-Eₐ₁|, the quotient |Eₐ₂-Eₐ₁|/b , i.e., a value obtained by dividing the above absolute value by the thickness (b nm) of the composition-modulated layer, may preferably be about 300 (at%/nm) or less, more preferably about 300 - 1 (at%/nm) (particularly preferably, about 300 - 5 (at%/nm)), in view of the stabilization of the above "matching".

In addition, when the difference between the composition ratio (at %) of the First Element (E_{b}) constituting the "Compound Layer A" and the First Element (E_{b}) constituting the "Compound Layer B" is denoted by |E_{b2}-E_{b1}|, the quotient |E_{b2}-E_{b1}|/b, i.e., a value obtained by dividing the above absolute value by the thickness (b nm) of the composition-modulated layer, may preferably be about 300 (at%/nm) or less, more preferably about 300 - 1 (at%/nm) (particularly preferably, about 300 - 5 (at%/nm)), in view of the stabilization of the above "matching".

The above-mentioned "quotient" of the First Element of the composition-modulated layer is also applicable to the "Second Element" in a similar manner.

### (Multilayer material)

The multilayer material according to the present invention has a structure wherein the above-mentioned compound layer and the composition-modulated layer are periodically stacked. Preferred examples of the multilayer structure are described below. In the following description of the multilayer structure, the compound layer is denoted by a symbol "C", and the composition-modulated layer is denoted by a symbol "M". The base material side of the multilayer structure is described on the left side, and the surface side of the multilayer material is described on the right side.

<When the multilayer material has two kinds of compound layers.>

C (composition: A) → M (composition: m) → C
(composition: B) → M (composition: n) → C
(composition: A) ····
(The above underlined portion corresponds to one period of the multilayer structure.)

<When the multilayer material has three kinds of compound layers.>

C (composition: A) → M (composition: m) C
(composition: B) → M (composition: n) → C
(composition: C) → M (composition: p) → C
(composition: A) ·····
(The above underlined portion corresponds to one period of the multilayer structure.)

In the above embodiment, the "one period" of the multilayer structure refers to the total of the film thicknesses of "C (composition: A) + M (composition: m) + C (composition: B) + M (composition: n)" (when the multilayer structure has two kinds of compound layers); or the total of the film thicknesses of °C (composition: A) + M (composition: m) + C (composition: B) + M (composition: n) + C (composition: C) + N (composition: p)" (when the multilayer structure has three kinds of compound layers).

### (Crystal structure)

In the present invention, the crystal structure or X-ray diffraction pattern of the entire multilayer material or the respective layers constituting the multilayer material may be any of ordinarily known crystal systems (such as cubic crystal system and hexagonal crystal system) without particular limitation. In view of an increase in the strain energy (or an improvement in the wear resistance based on such an increase in the above energy), it is preferred that at least one kind of the compound layer constituting the above "at least two kinds of compound layers" has a different crystal structure from another layer (another compound layer and/or a composition-modulated layer) at normal temperature, at atmospheric pressure (normal pressure), and in an equilibrium state, and that the multilayer material has a single X-ray diffraction pattern (i.e., an X-ray diffraction pattern corresponding to a single crystal system) as a whole. In view of the oxidation resistance or chemical stability, it is preferred that each of the layers constituting the multilayer material has a crystal structure of either of the cubic crystal system or the hexagonal crystal system, and the multilayer material has an X-ray diffraction pattern corresponding to the cubic crystal system as a whole.

For example, such a crystal structure or X-ray diffraction pattern of each layer or the entire multilayer material may be confirmed by means of X-ray diffraction under the following conditions.

### <Condition for X-ray diffraction>

X-ray diffractometer: trade name: RINT-1500, mfd. by Rigaku Denki Co.

Observation of X-ray diffraction peak: A diffraction line or image is observed by means of a diffractometer equipped with a copper target and a nickel filter, by use of a thin-film X-ray diffraction method (angle of incidence θ = 1°)
X-ray source: Cu-Kα ray (1.54 Å (angstrom))

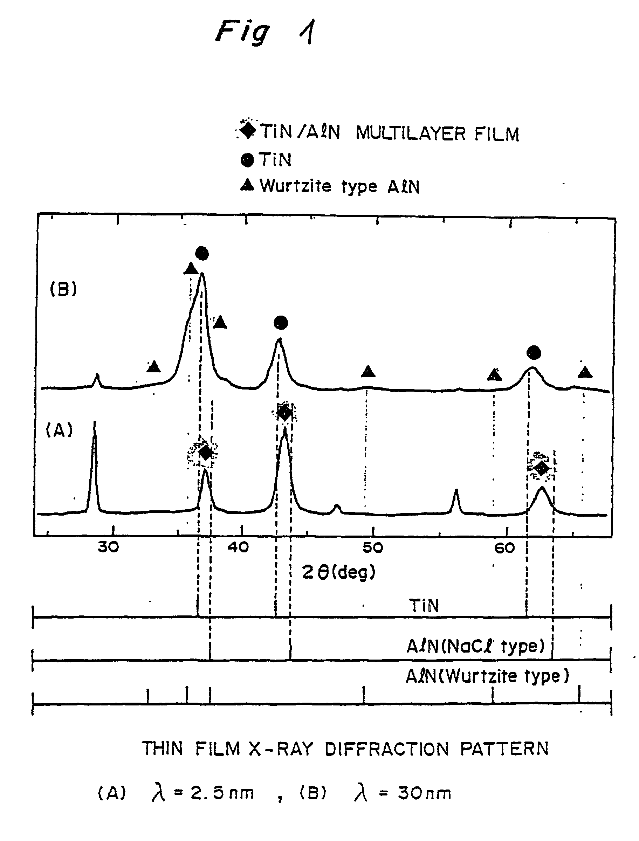

Fig. 1 to Fig. 8 show typical X-ray diffraction patterns of a thin film or multilayer film which has been formed on a substrate of sintered WC-Co (including TiC as a sintering assistant).

Fig. 1 schematically shows a thin film X-ray diffraction pattern. In this figure, " 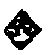 " denotes TiN/AlN multilayer film, the symbol " 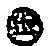 " denotes TiN, and " 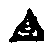 " denotes Wurtzite-type (hexagonal crystal system) AlN.

In Fig. 1, the pattern (A)(λ = 2.5 nm) assumes a pattern of single cubic crystal system (not a pattern of hexagonal crystal system). Further, the position of a peak (abscissa = angle of diffraction) is located between those of TiN and cubic crystal AlN. The diffraction pattern of the composition-modulated film in the above embodiment is characterized by these two points (i.e., that the pattern thereof is formed into the pattern of a single crystal system, and that the diffraction peak is located between those of the "two kinds of the compound layers").

On the other hand, the pattern (B): λ = 30 nm assumes a pattern which has been provided by the combination (superposition) of the TiN pattern and the hexagonal crystal AlN pattern (the hexagonal crystal AlN pattern is very weak).

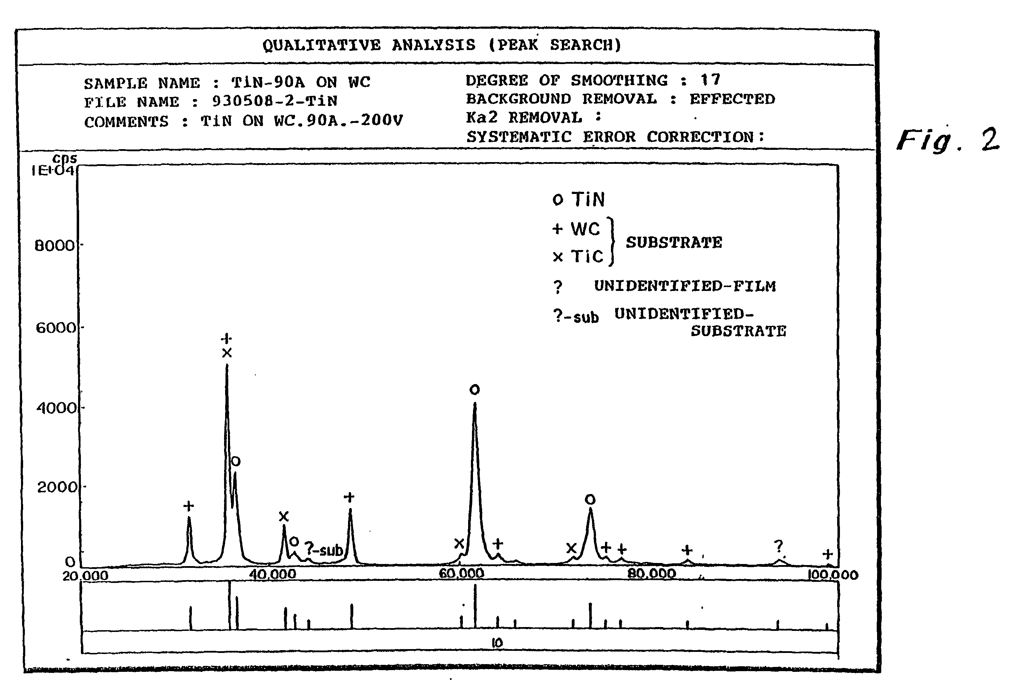

The symbol "○" in Fig. 2 denotes a typical diffraction pattern of cubic crystal system (TiN). In Fig. 2, the symbol "+" denotes WC (substrate), "×" denotes TiC (substrate), "?" denotes a peak based on a film, and "? -Sub" denotes a peak based on a substrate.

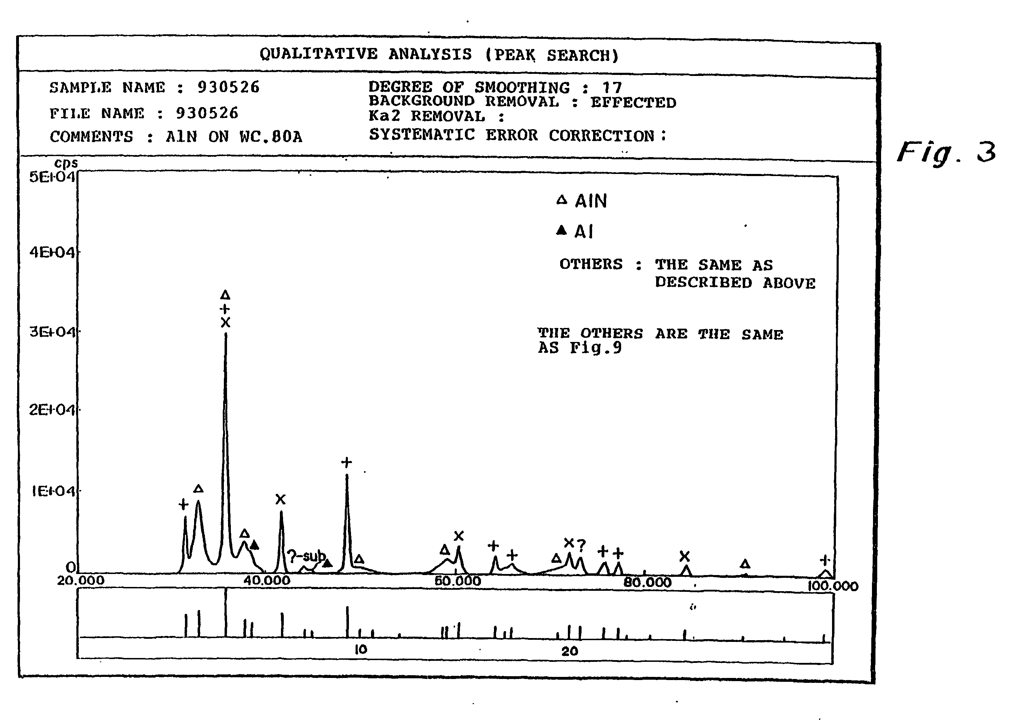

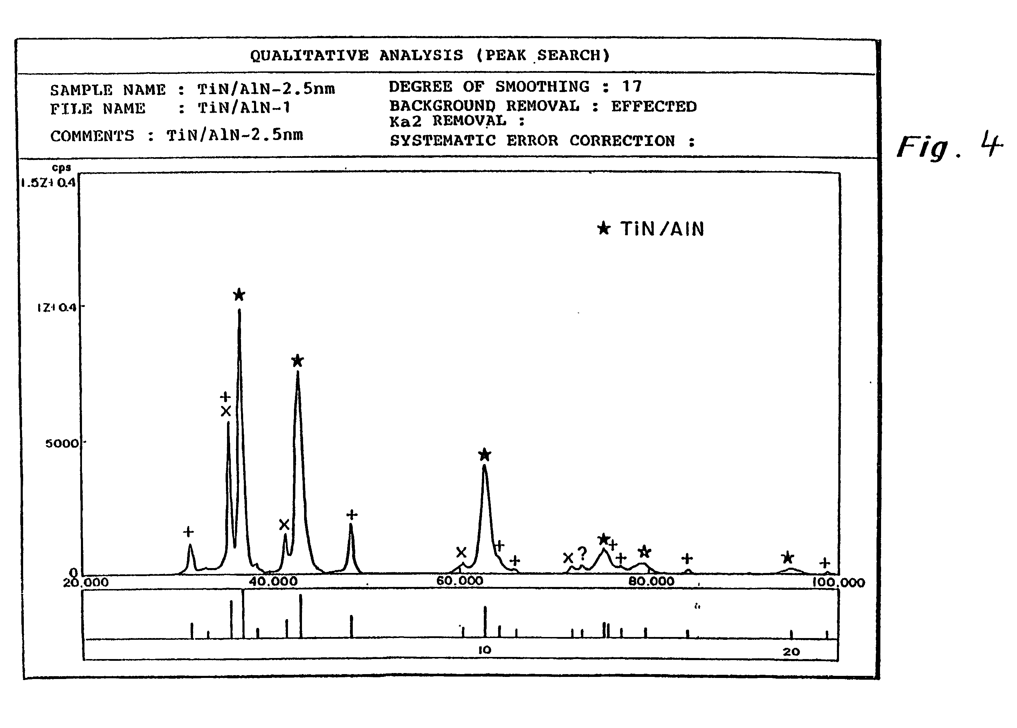

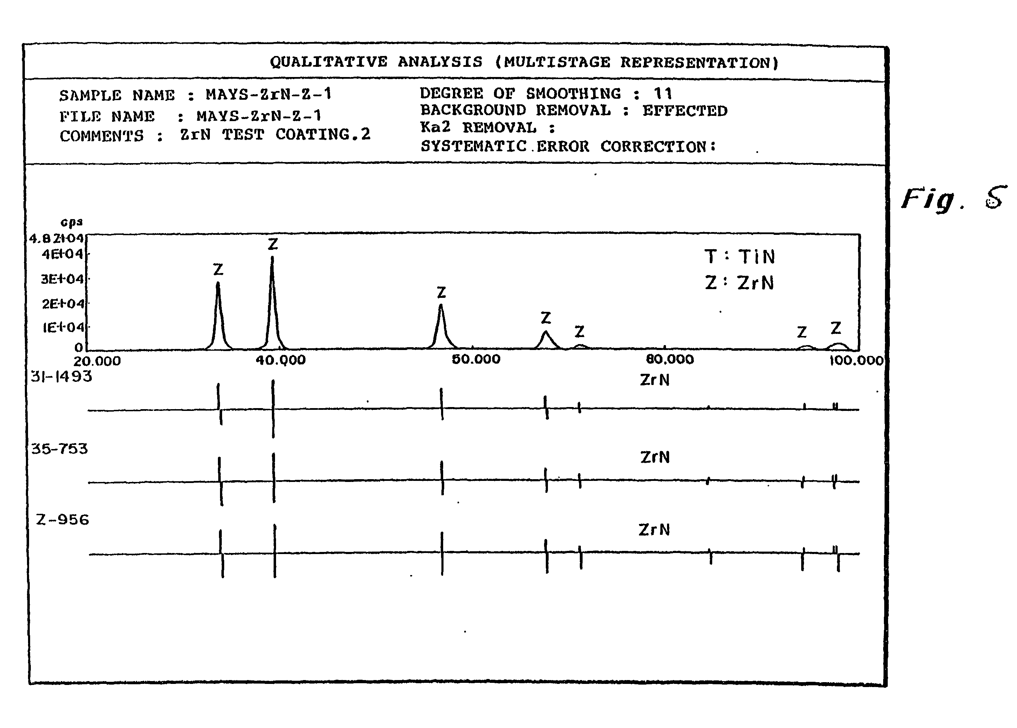

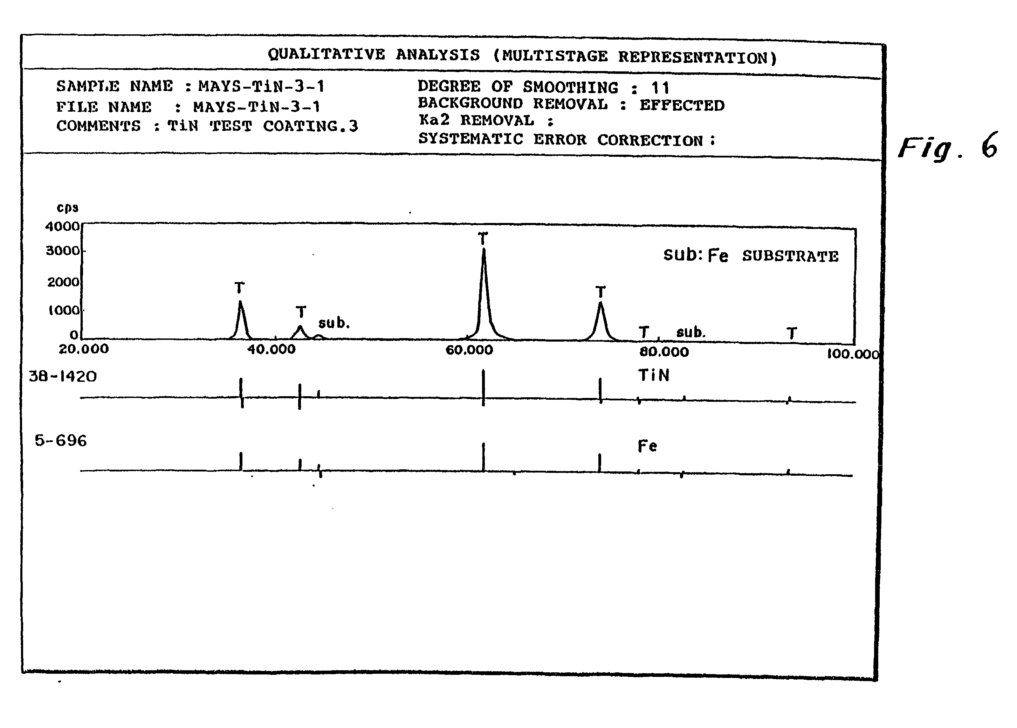

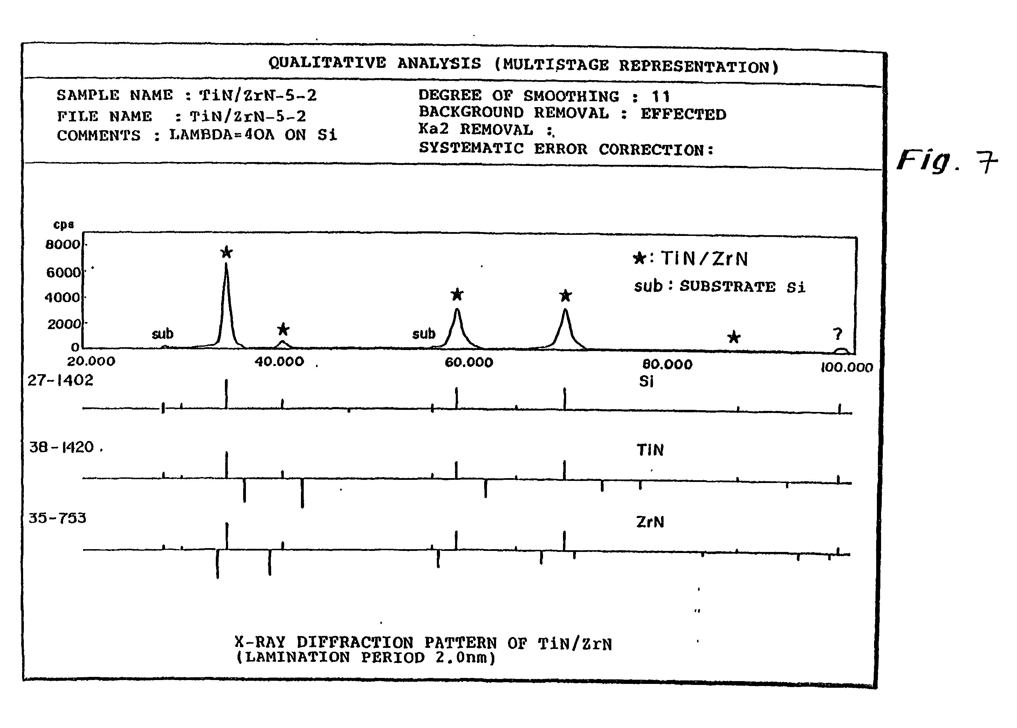

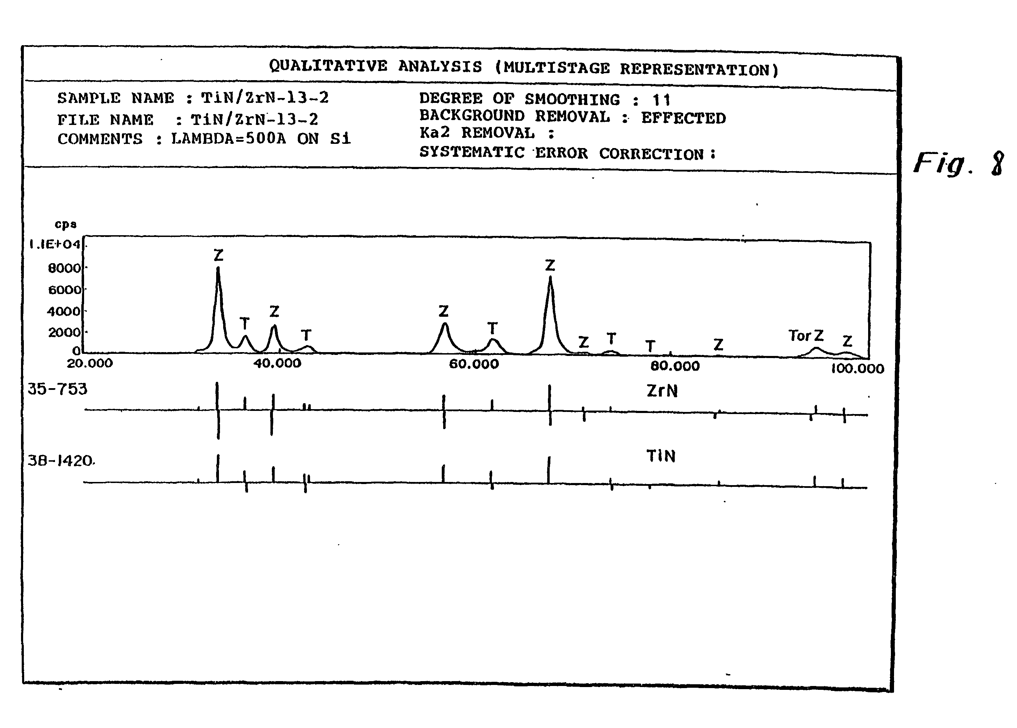

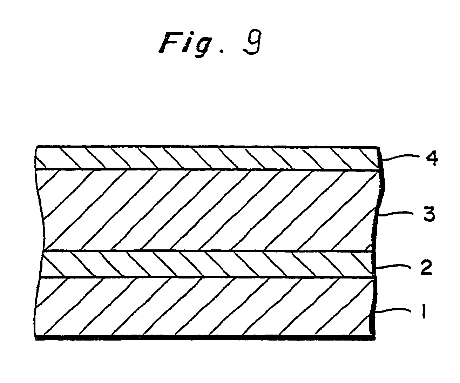

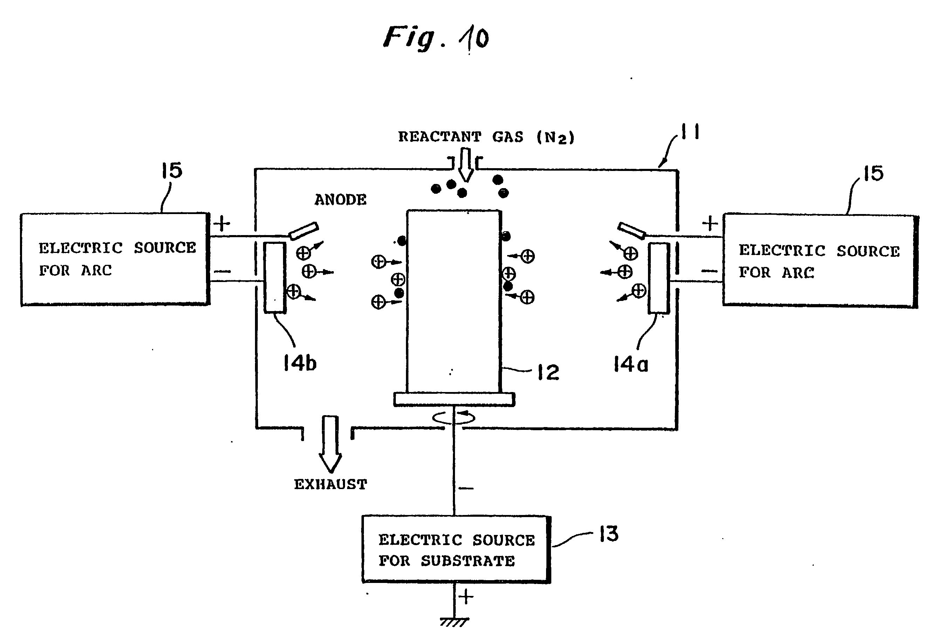

The symbol "Δ" in Fig. 3 denotes a typical diffraction pattern of cubic crystal system (TiN). In Fig. 3, the symbol "▲" denotes Al. Other symbols in this figure are the same as those in the above Fig. 2.

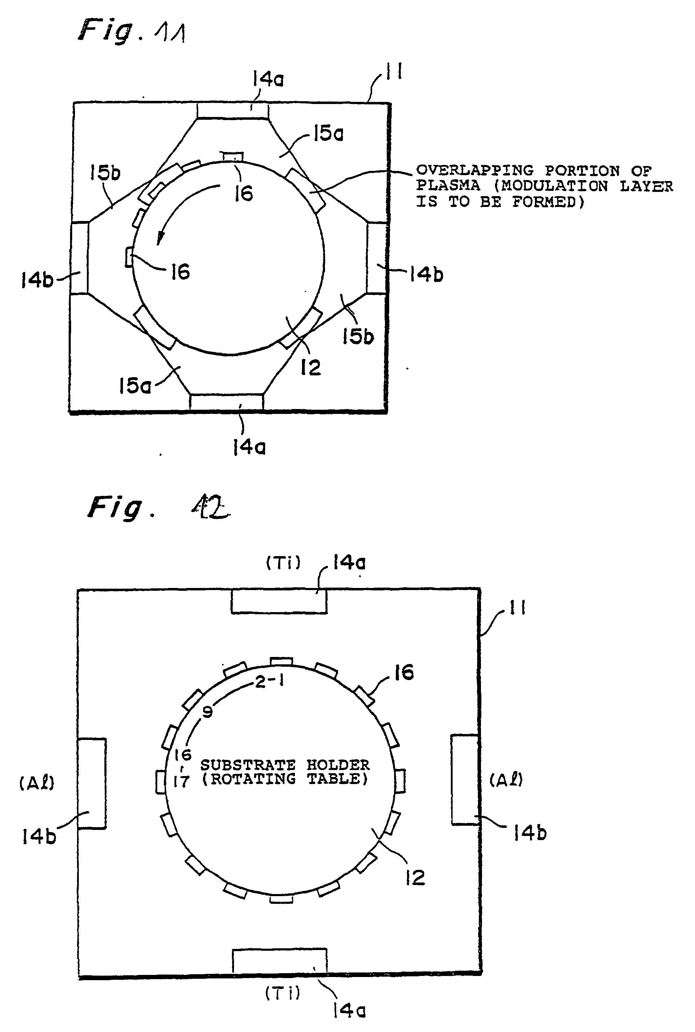

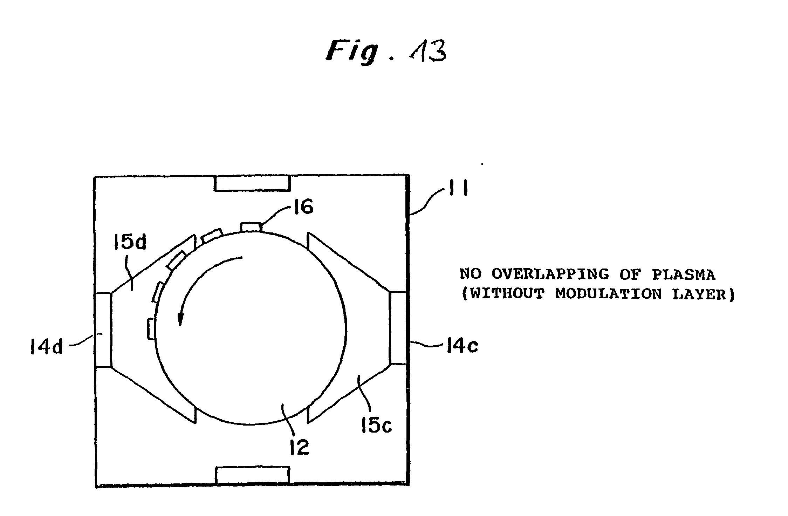

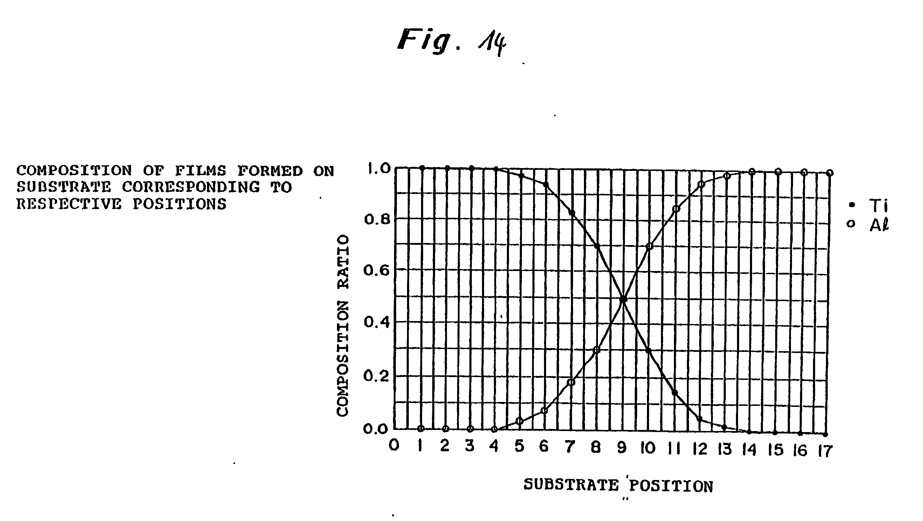

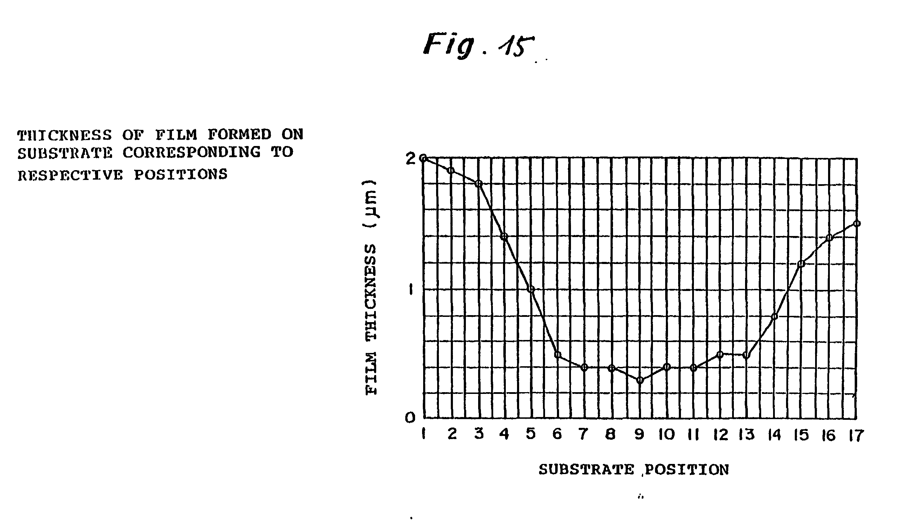

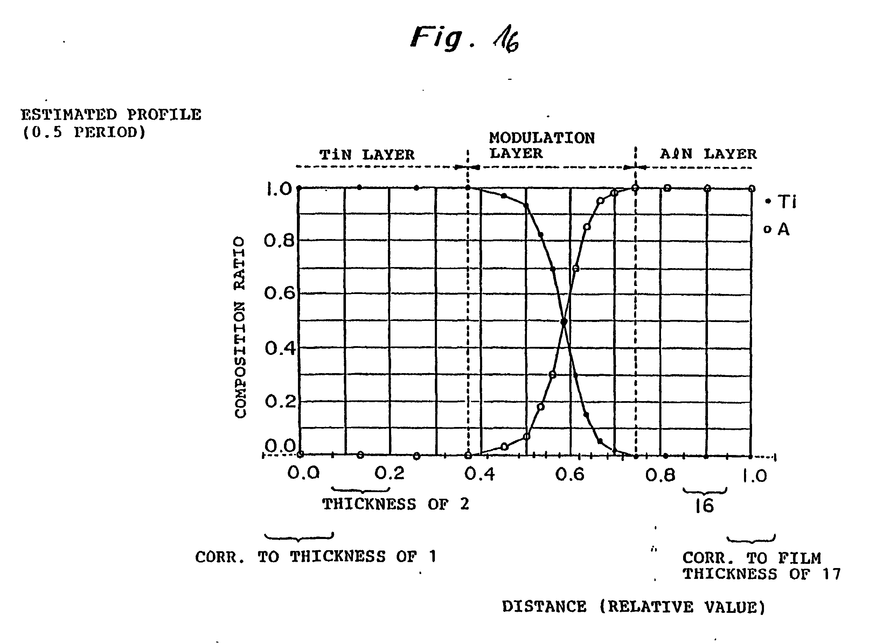

Fig. 4 shows a typical diffraction pattern (a single pattern) of TiN/AlN modulation film.

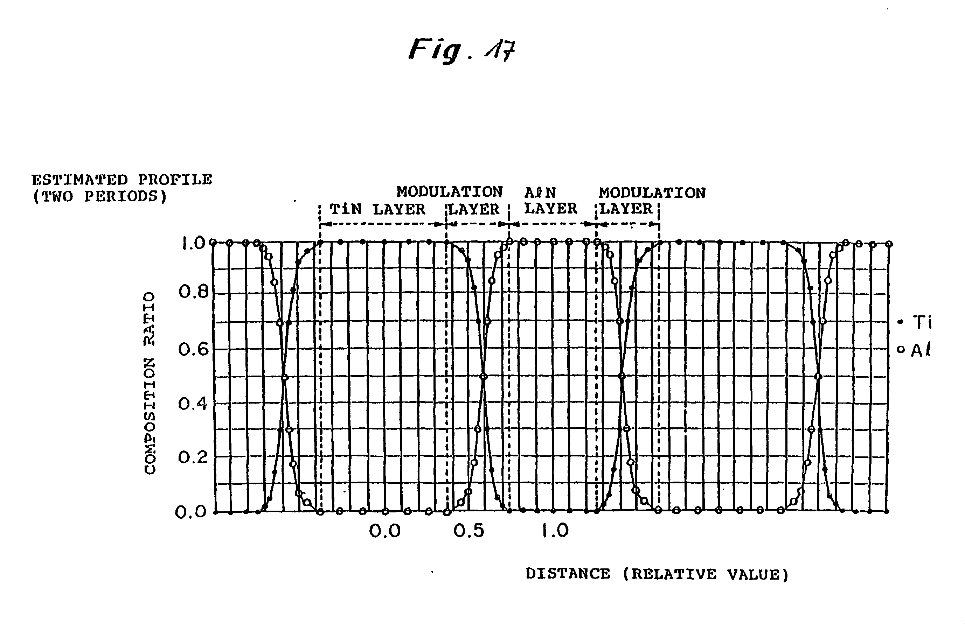

Fig. 5 shows a typical diffraction pattern of ZrN (cubic crystal system), and Fig. 6 shows a diffraction pattern of TiN. The symbol "T" denotes TiN and the symbol "Z" denotes ZrN.

Fig. 7 shows a typical pattern of TiN/ZrN modulation film (single pattern). In Fig. 7, a diffraction pattern of cubic crystal system is shown, and the peak position is located between those of TiN and ZrN.

On the other hand, Fig. 8 shows a typical pattern of TiN/ZrN modulation film (not a single pattern). Fig. 8 shows a diffraction pattern based on a combination of two cubic crystal system patterns (TiN pattern and ZrN pattern) respectively having somewhat different peak positions.

As described above, when the multilayer has a single diffraction pattern as a whole, it may provide a typical pattern of Fig. 4 or Fig. 7.

However, in some cases, the multilayer material may also provide a unified pattern comprising a combination of the above-mentioned unified X-ray diffraction pattern and the X-ray diffraction pattern of each of the layers constituting the multilayer film, when the multilayer film simultaneously includes a portion (composition-modulated film) wherein the strains are matched and another portion wherein the strains are not matched, e.g., on the basis of a dispersion in the period (film thickness).

In the present invention, it is particularly preferred that the above-mentioned two kinds of the compound layers respectively comprise a TiN layer and an AlN layer, and the composition-modulated layer comprises a TiAlN layer. In such a case, the TiN layer and AlN layer as the compound layers are contrary to each other with respect to their crystal structures, and they may accumulate a maximum strain energy, and therefore the hardness of the composition-modulated layer becomes so high in a desirable manner.

In the present invention, in view of the balance between the wear resistance and the adhesion to a base material, the total film thickness of the above multilayer material may preferably be about 5 nm to 15 µm, more preferably about 0.5 µm to 10 µm. When the total film thickness is below 5 nm, the improvement in the wear resistance is liable to be insufficient. On the other hand, when the total thickness exceeds 15 µm, the adhesion strength between the multilayer material and the base material can be decreased in some cases, e.g., due to the influence of residual stress in the film constituting the multilayer material, etc.

### (Base material)

The above-mentioned multilayer material according to the present invention is disposed on a WC-based hard material as a base material.

### (Intermediate layer)

As the multilayer material according to the present invention is formed on the above base material, in order to further improve the adhesion strength between the multilayer material and the base material, an intermediate layer is disposed for improving the adhesion strength of the multilayer material. For example, when the base material and the multilayer material (the layer constituting the multilayer material nearest to the base material) comprise different substances respectively having considerably different characteristics, the change in the above characteristics may be gradually or stepwise controlled and the residual stress in the film may also be reduced, by disposing an intermediate layer having an intermediate characteristic between the base material and the multilayer material.

In view of an effective improvement in the adhesion strength between the base material and the multilayer material, the above intermediate layer has a composition comprising one compound being (Ti0.4, Al0.6) or Nb and the element N (hereinafter, referred to as "Fourth Element").

In the present invention, in view of an improvement in the adhesion strength between the base material and the multilayer material, or in view of advantageous matching therebetween, it is preferred that the intermediate layer has a composition which is the same as or similar to the composition of the layer adjacent to the intermediate layer (i.e., the compound layer or composition-modulated layer). More specifically, it is preferred that the intermediate layer has a chemical property as well as a crystal structure similar to that of the adjacent layer. From such a viewpoint, the intermediate layer and the multilayer portion (the lowermost layer, or layer nearest to the base material) may preferably contain a common element (Third Element and/or Fourth Element).

More specifically, when the composition ratio (at %) of the Third Element in the above intermediate layer is denoted by "c", and the composition ratio (at %) of the Third Element in the lowermost layer constituting the multilayer portion adjacent to the intermediate layer is denoted by "d", the value of |d - c|/c may preferably be not more than 10 %, more preferably not more than 5 %.

In the present invention, in view of a similar chemical property in the multilayer portion and the intermediate layer, it is further preferred that a common element is included in the First Element constituting the multilayer portion and the Third Element constituting the intermediate layer; and a common element is included in the Second Element constituting the multilayer portion and the Fourth Element constituting the intermediate layer. From such a viewpoint, it is particularly preferred that the compound constituting the intermediate layer is the same as "at least one compound" included in the multilayer portion.

In the present invention, the intermediate layer may preferably have a thickness of 0.05 µm or more, more preferably about 0.05 - 5 µm (particularly preferably, about 0.05 - 1 µm). When the film thickness of the intermediate layer is below 0.05 µm, the improvement in the adhesion strength is liable to be insufficient. On the other hand, when the film thickness exceeds 5 µm, the improvement in the adhesion strength tends to be rather saturated, and the resultant productivity also tends to be lowered.

For example, the thickness of the intermediate layer may be confirmed by means of TEM measurement in the same manner as in the measurement of the thickness of the compound layer as described hereinabove.

On the other hand, the intermediate layer may preferably have a thickness of 5 µm or less, more preferably about 0.02 µm (20 nm) to 1 µm, particularly preferably about 0.02 - 0.5 µm. When the film thickness of the intermediate layer is below 20 nm, the effect of "matching" based on the intermediate layer is liable to be insufficient. On the other hand, when the film thickness exceeds 5 µm, the entire hardness is liable to be lowered whereby the stacking effect in the multilayer portion is liable to be impaired.

### (Columnar crystal)

In the present invention, in order to enhance the matching, effect based on the above intermediate layer, the intermediate layer may preferably comprise a columnar crystal. The term "columnar crystal" used herein refers to a polycrystal structure wherein crystal grains constituting the polycrystal have a shape elongated in a direction which is substantially parallel to the growth direction of the intermediate layer. In general, the thickness direction of the intermediate layer does not necessarily coincide with the growth direction thereof. In a case where the intermediate layer is formed by using a vapor-phase deposition method, when the evaporation source (target) for the deposition is just in front of the base material on which the intermediate layer is to be disposed, the thickness direction of the intermediate layer coincides with the growth direction thereof. However, when the base material is disposed oblique to the evaporation source (e.g., oblique to a direction of the side face of the base material), the columnar crystals may be grown in a direction which is oblique to the direction of the evaporation source, in some cases.

The presence of the above columnar crystal, and the growth direction of the respective crystal grains may be confirmed by means of a TEM (magnification: about 20 x 10₄), or HR-SEM (high-resolution scanning electron microscope, magnification: about 20 × 10₄). Each of the crystal grains may preferably have a ratio of the length (i.e., the dimension in the growth direction)/diameter of 1 or more.

The above-mentioned "direction which is substantially parallel to the growth direction of the intermediate layer" refers to a direction such that it forms an angle of ±45° or less (more preferably ±15° or less) with respect to the growth direction of the intermediate layer.

In the columnar crystal constituting the intermediate layer, when the section (in the thickness direction) of the intermediate layer is observed with the above-mentioned TEM or HR-SEM, the ratio of S_{c}/(S_{c} + Sₚ) may preferably be 50 % or more, more preferably 80 % or more (particularly preferably, 90 % or more), provided that the total area of the "columnar crystal portion" is denoted by S_{c}, and the total area of the "portion (such as micro-grain portion and micro-columnar portion) other than the columnar crystal portion" is denoted by Sₚ.

The diameter of the above columnar crystal (the average diameter obtained by averaging the respective diameters of at least five columnar crystals randomly selected) may preferably be 10 nm or more, more preferably about 20 nm to 1 µm (particularly preferably, about 20 nm to 0.2 µm). When the above diameter is below 10 nm (further, below 20 nm), the matching effect of the intermediate layer is liable to be insufficient, because the diameter tends to become larger in the multilayer portion. On the other hand, when the above diameter exceeds 1 µm, a crack is liable to be produced in the growth direction, and a defect of the film is liable to occur.

The means or measure for changing the diameter of the columnar crystal constituting the intermediate layer is not particularly limited. For example, the diameter of the columnar crystal may be regulated by changing the temperature of the substrate on which the intermediate layer is to be deposited, a bias voltage, the atmosphere or pressure of an environment for the film formation. In view of easiness in the regulation of the diameter, it is preferred to change the temperature of the substrate on which the intermediate layer is to be deposited so as to regulate the diameter of the columnar crystal.

In view of an improvement in the matching between the intermediate layer and the lowermost layer of the multilayer portion, it is preferred that the intermediate layer has a crystal structure (such as cubic crystal and hexagonal crystal) which is the same as the crystal structure of the lowermost layer of the multilayer portion (i.e., a combination such as cubic crystal-cubic crystal, and hexagonal crystal-hexagonal crystal). In view of the lattice constant (i.e., unit vectors a, b and c; and angles between the unit vectors of α, β and γ), the misfit, i.e., (a_{c} - aₛ)/ a_{c}, between the lattice constant (unit vector a) a_{c} of the intermediate layer and the lattice constant aₛ of the lowermost layer of the multilayer portion, may preferably be 15 % or less, more preferably 10 % or less (particularly preferably, 5 % or less). When the lattice constants of the at least two kinds of compound layers are respectively denoted by a₁ and a₂ (a₁ ≦ a₂), the lattice constant a_{c} of the intermediate layer may preferably have an intermediate value between these lattice constant values, i.e., a value satisfying a relationship of a₁ ≦ a_{c} ≦ a₂.

The lattice constants of some nitrogen compounds and the misfit between the respective nitrogen compounds are shown in Fig. 13 (Table 8).

### (Composition-modulated layer)

As the above intermediate layer is provided, in view of further stabilization of the matching in the multilayer portion, a composition-modulated layer as described hereinabove is disposed between the adjacent compound layers (i.e., compound layers located nearest to each other).

In the above embodiment wherein the composition-modulated layer is provided in the multilayer portion, at least the periodic structure thereof comprising the compound layer and the composition-modulated layer does not have an interface (a face or plane at which the composition is discontinuous). More specifically, the respective layers constituting the conventional multilayer film have interfaces between the respective layers. On the contrary, the above-mentioned multilayer material according to the present invention does not have such an interface, at least in the periodic structure thereof comprising the compound layer and the composition-modulated layer, but the at least two kinds of compound layers are disposed adjacent to the above composition-modulated layer.

### (Surface layer)

On the uppermost layer (topmost surface) of the multilayer material according to the present invention, it is possible to dispose a surface layer for improving the wear-resistant performance, as desired. For example, when the multilayer material according to the present invention is used as a wear-resistant coating, the topmost surface thereof is exposed to an extremely severe environment (such as wearing at a high temperature) in many cases, and therefore the topmost surface is liable to be reacted with the atmosphere surrounding the surface or a counter material (such as workpiece) wearing with the above topmost surface. When such wearing occurs, the surface of the coating is liable to be deteriorated, and the wear resistance thereof can be impaired. Accordingly, the uppermost layer constituting the multilayer material may preferably have a composition which has a low reactivity with the counter material. On the other hand, in consideration of the productivity at the time of the multilayer film formation, etc., such a composition having a low reactivity is not necessarily preferred.

When a surface layer having a composition having an excellent resistance to the atmosphere (in which the multilayer material is to be used) and to the reaction with the counter material is disposed on the uppermost layer of the multilayer material, the wearing of the surface of the multilayer material due to a surface reaction, etc., may be suppressed by use of such a surface layer, thereby to increase the latitude or degree of freedom in the selection of the compositions of the respective layers constituting the multilayer material.

In view of an effective improvement in the wear resistance and the adhesion strength between the surface layer and the multilayer material (uppermost layer), the surface layer may preferably comprise Ti (hereinafter, referred to as "Fifth Element") and N or C (hereinafter, referred to as "Sixth Element").

In the present invention, in view of an improvement in the adhesion strength between the surface layer and the layer (compound layer or composition-modulated layer) adjacent to the surface layer, it is preferred that the surface layer has a composition which is the same as or similar to the above adjacent layer, in the same manner as in the case of the above-mentioned intermediate layer.

In the present invention, the surface layer may preferably have a thickness of 0.05 µm or more, more preferably about 0.05 - 5 µm (particularly preferably, about 0.05 - 1 µm). When the film thickness of the surface layer is below 0.05 µm, the improvement in the wear resistance is liable to be insufficient. On the other hand, when the film thickness exceeds 5 µm, the peeling or exfoliation of the surface layer is rather liable to occur, and the improvement in the wear resistance tends to become insufficient.

For example, the thickness of the surface layer may be confirmed by means of TEM measurement in the same manner as in the measurement of the thickness of the compound layer as described hereinabove.

Fig. 9 is a schematic sectional view showing an embodiment of the structure of the multilayer material according to the present invention, wherein both of the above intermediate layer and the surface layer are provided. Referring to Fig. 9, the multilayer material in this embodiment comprises: a base material 1 comprising a hard metal, etc.; an intermediate layer 2 disposed on the base material 1; a periodic multilayer 3 disposed on the intermediate layer 2; and a surface layer 4 disposed on the periodic multilayer 3. The periodic multilayer 3 comprises: at least two kinds of compound layers respectively having different compositions; and a composition-modulated layer disposed between the compound layers.

When the multilayer material according to the present invention is used as a coating layer for a cutting tool (cutting tip), the "flank face" and the "cutting face (or rake face)" of the cutting tool may be respectively coated with multilayer materials having different periods, as desired, depending on the characteristics required for the respective faces of the cutting tool.

### (Adhesion layer)

As the multilayer material including an intermediate layer according to the present invention is formed on the above base material, in view of a further improvement in the adhesion strength between the base material and the intermediate layer, an adhesion layer is disposed between the base material and the intermediate layer for improving the adhesion strength therebetween. The adhesion layer is disposed separately from the above intermediate layer, and the intermediate layer may mainly contribute to an improvement in the wear resistance from an aspect of physical property (e.g., matching between the crystal lattices). On the other hand, the adhesion layer may mainly contribute to an improvement in the wear resistance from an aspect of chemical property. In other words, the function of improving the wear resistance may be function-separated into the above two layers, and therefore the latitude or degree of freedom in the selection of the materials to be used for such a purpose may be increased.

For example, when the base material and the multilayer material (the layer thereof nearest to the base material) respectively comprise substances having considerably different characteristics (e.g., chemical characteristic), the change in the above characteristic may gradually be regulated and the residual stress, etc., in the film may be reduced by disposing an adhesion layer having an intermediate characteristic between the base material and the multilayer material.

In view of an effective improvement in the adhesion strength between the base material and the multilayer material, the adhesion layer comprises Ti (hereinafter, referred to as "Seventh Element") and the element N (hereinafter, referred to as "Eighth Element").

In the present invention, in view of an improvement in the adhesion strength between the base material and the intermediate layer (multilayer material), it is preferred that the adhesion layer has a composition which is the same as or similar to the composition of the intermediate layer adjacent to the adhesion layer, similarly as in the case of the above-mentioned intermediate layer.

In the present invention, the adhesion layer may preferably have a thickness of 0.05 µm or more, more preferably about 0.05 - 5 µm (particularly preferably, about 0.05 - 1 µm). When the film thickness of the adhesion layer is below 0.05 µm, the improvement in the adhesion strength is liable to be insufficient. On the other hand, when the film thickness exceeds 5 µm, the improvement in the adhesion strength tends to be rather saturated, and the resultant productivity also tends to be lowered.

For example, the thickness of the adhesion layer may be confirmed by means of TEM measurement in the same manner as in the measurement of the thickness of the compound layer as described hereinabove.

### (Process for forming multilayer material)

As the process for forming the multilayer material according to the present invention (in addition, an intermediate layer and/or surface layer, as desired), it is possible to utilize a vapor-phase deposition method such as CVD. method and PVD method without particular limitation. When the PVD method (such as sputtering method and ion plating method) is used, it is easier to retain the strength of the base material as compared with the CVD method, and it is easy to retain the wear resistance, resistance to breakage, etc., at a high level in the use thereof for tools, etc. In the present invention, in view of easiness in the formation of a layer having a crystal structure of cubic crystal system and/or hexagonal crystal system, it is preferred to use an ion plating method (particularly, an arc-type ion plating method) which is capable of providing a high ionization efficiency and of forming a layer having a high crystallinity, among various PVD methods as described above.

When a gas is used as a raw material, it is also possible to introduce an inert gas such as Ar and He, a gas having an etching effect such as H₂, etc., in addition to the raw material gas, for the purpose of improving the crystallinity of a compound to be formed. In such a case, it is possible to introduce the above inert gas and/or etching gas separately from, or simultaneously with, the introduction of the raw material gas into the film forming apparatus.

### (Formation of multilayer material by using arc-type ion plating method)

There is described an embodiment of the process for forming the multilayer material according to the present invention by using an ion plating method based on vacuum arc discharge (arc-type ion plating method).

Fig. 10 is a schematic sectional view in the vertical direction showing an example of the film forming apparatus for forming the multilayer material according to the present invention by using an arc-type ion plating method.

Referring to Fig. 10, a base material holder 12 for holding a base material (not shown) is rotatably disposed in a vacuum chamber 11, and an electric source 13 for the base material is electrically connected to the base material holder 12. On the other hand, a plurality of targets 14 are disposed on the inner wall of the vacuum camber 11 located opposite to the base material holder 12, and an electric source 15 for the arc formation is electrically connected to the target 14.

Referring to Fig. 11 which is a schematic plan view showing the above film forming apparatus, a base material 16 on which a multilayer material according to the present invention is to be deposited is disposed on the outer surface of the above-mentioned base material holder 12 so that the base material 16 is disposed opposite to a predetermined target (14a or 14b) depending on the rotation of the base material holder 12. In such a film forming apparatus, the layer thickness of each layer constituting the multilayer material can be controlled by regulating the rotating speed of the base material holder 12, and the discharging current for the vacuum arc (i.e., the amount of the vaporization of target material 14a and/or 14b). The change in the thickness and composition of the composition-modulated layer can be controlled by regulating the degree of the overlapping between the plasmas 15a and 15b based on the targets 14a and 14b, respectively. The degree of the "overlapping" of the plasmas may be changed by using the location of the respective targets 14a and 14b and/or the pressure at the time of the film formation based on the arc current.

When the multilayer material according to the present invention is formed by using such a film forming apparatus, e.g., the following process may be employed.

Thus, at first, the vacuum chamber 11 is evacuated into a vacuum condition (pressure: about 1.332 x 10⁻³ Pa (10⁻⁵ Torr), and then Ar (argon) gas is introduced into the vacuum chamber 11 so as to provide a pressure of about 10⁻² Torr. While such a pressure is maintained, the base material 16 is heated to about 200-800 °C and a voltage. of about -800 V to -1000 V is applied to the base material 16 to clean the surface of the base material 16, and thereafter the Ar gas is exhausted. Then, the targets 14a and 14b are evaporated or ionized by use of vacuum arc discharge, while one or plural kinds of gases such as N₂ gas and CH₄ gas is introduced into the vacuum chamber 11 at a rate of about 25-400 cc/min., in a time-controlled manner in accordance with the rotation of the base material 16. In this manner, when the base material 16, which is moved on the basis of the rotation of the base material holder 12, is passed through the position located in front of the target 14a or 14b, a layer of a compound comprising the corresponding target material and C and/or N, etc., contained in the introduced gas is formed on the base material 16.

Referring to Fig. 11, when the base material 16 is placed at a position so that it is disposed opposite to the target 14a at the time of the formation of the above multilayer film, a layer of a compound (e.g., TiN) comprising an element (e.g., Ti) constituting the target 14a and an element (such as N) contained in the introduced gas is formed on the base material 16.

On the other hand, when the base material 16 is placed at a position corresponding to a position between the targets 14a and 14b, a layer of a compound (e.g., (TiₓAl₁₋ₓ)N) comprising an element (e.g., Ti) constituting the target 14a, an element (e.g., Al) constituting the target 14b, and an element (such as N) contained in the introduced gas is formed on the base material 16. At the time of the formation of such a TiAlN layer, the composition of the above compound (TiₓAl₁₋ₓ)N is determined depending on the degree of the "overlapping" between the plasma 15a based on the target 14a, and the plasma 15b based on the target 14b (In other words, the relative positional relationship of the base material 16 with respect to the targets 14a and 14b). The composition of the above compound is continuously changed corresponding to the positional range of the base material 16 ranging from the position thereof at which it is disposed opposite to the target 14a, to the position thereof at which it is disposed opposite to the target 14b. Accordingly, when such a layer formation process is employed, it is possible to form a composition-modulated film having a continuous composition of (TiₓAl₁₋ₓ)N.

Further, when the base material 16 is placed at a position so that it is disposed opposite to the target 14b, a layer of a compound (e.g., AlN) comprising an element (e.g., Al) constituting the target 14b and an element (such as N) contained in the introduced gas is formed on the base material 16. Accordingly, when the above-mentioned procedure is employed, it is possible to form a periodic multilayer (or stacking) structure comprising: a compound layer (TiN) → a composition-modulated layer (Tiₓ, Al₁₋ₓ)N → a compound layer (AlN) → a composition-modulated layer (Tiₓ, Al₁₋ ₓ)N → a compound layer (TiN) → ········.

The thickness and/or composition of the respective layers (such as compound layer and composition-modulated layer) can be controlled by regulating the degree of the "overlapping" between or among the plasmas based on the respective targets. The degree of the "overlapping" of the plasmas may be controlled by using the location of the respective targets, arc current, and/or the pressure at the time of the film formation.

### (Period for rake face/flank face)

According to the present inventors' knowledge, in the tip of a cutting tool, etc., it has been confirmed that cutting performance and life of a cutting tip are remarkably improved, when the period of the multilayer film to be disposed on the rake face thereof (i.e., the face at which crater wear is liable to occur) is made larger than the period of the multilayer film to be disposed on the flank face thereof (i.e., the face at which flank wear is liable to occur).

On the other hand, for a different tip configuration or different cutting use, in some cases, it has been confirmed that cutting performance and life of a cutting tip are remarkably improved, when the period (j) of the multilayer film on the flank face thereof is made larger than the period (k) of the multilayer film the rake face thereof, contrary to the above case.

According to the present inventors' knowledge, it has been presumed that the above-mentioned phenomena are based on a fact that respective characteristics such as wear resistance and oxidation resistance required for the flank and rake faces are ordinarily different depending on the usage of the corresponding cutting tool, and therefore the period of the multilayer material suitable for these characteristics are also somewhat different.

### (Characteristic and intended use of multilayer material)

The multilayer material according to the present invention (surface side) may preferably have a Vickers hardness of 3 x 10³ kgf/mm² or more, more preferably 3.2 ×10³ kgf/mm² or more (particularly preferably, 3.4 × 10³ kgf/mm² or more), under the application of a load of 25gf. Such a Vickers hardness may be measured by a known measurement method (e.g., a method using a micro-micro-hardness tester described in Japanese Industrial Standard (JIS) B-7744-1991). The vickers hardness of 3 x 10³ kgf/mm² under a load of 25gf is approximately equivalent to a Vickers hardness of 4 × 10³ kgf/mm² under a load of 1gf.

The multilayer material according to the present invention is useful as a surface coating material for a hard member such as tool (tip, drill, end mill, etc.) and wear-resistant tool. In addition, the multilayer material according to the present invention is also useful as a surface coating material for an electric or electronic component, or a sliding or machine part, etc.

When the multilayer material according to the present invention is used as a wear-resistant film or protective film for an electric, electronic, sliding or machine part or component, a total film thickness of about 5 nm to 10 µm (more preferably, about 5 nm to 0.5 µm) is preferred in the case of the electric or electronic component, and a total film thickness of 0.1 µm to 10 µm (more preferably, about 0.5 - 5 µm) is preferred in the case of the machine part.

Hereinbelow, the present invention will be described in more detail with reference to specific Examples.

### Examples

In the Examples appearing hereinafter, the layer thicknesses and periods of the respective compounds constituting an ultra-thin multilayer material were determined by the observation with a transmission electron microscope (TEM). The change in the composition of each layer was confirmed by means of a micro-area EDX attached to the above TEM. The crystal structures of entirety of ultra-thin film multilayer materials were determined by means of an X-ray diffraction pattern, the crystal structure of a minute portion was determined by means of a TED (selected-area electron beam diffraction) pattern of a transmission electron microscope. The observation of X-ray diffraction peaks was conducted by observing a diffraction line or image based on Cu-Kα ray in a thin-film X-ray diffraction method by means of a diffractometer using a copper target and a nickel filter. In addition, the hardness of a film was measured by using the above-mentioned known Vickers hardness measurement method under a load of 25gf.

In the Example appearing hereinafter, matching property between the intermediate layer and the multilayer portion was confirmed by direct observation with the TEM, and a TED pattern of the boundary potion therebetween.

In the Examples, the film formation was basically conducted by forming, on a base material, an adhesion layer), an intermediate layer, a wear-resistant layer (multilayer portion), and a surface layer (if any) in this order, while changing the target for discharge and/or a gas to be introduced, as desired.

The film formation was conducted by using a film forming apparatus (Fig. 11) wherein four raw material targets were disposed at predetermined positions to form an angle of 90 ° therebetween so that the plasmas based on the targets were overlapped with each other.

### Example

Only samples 29 to 34 and 35 to 40 described below are embodiments of the invention.

As a base material, there was used a cutting tip (having dimensions of about 1.3 cm x 1.3 cm × 0.4 cm) which was made of a cemented carbide having a composition according t the JIS specification P30 (JIS B-4053-1989), and having a shape according to the JIS specification SNGN-120408 (JIS B-4121-1985).

The above-mentioned base material 16 was mounted to the substrate holder 12 of a film forming apparatus as shown in the schematic plan view of Fig. 12, and a multilayer material according to the present invention was formed onto a surface of the base material 16 by using an ion plating method based on vacuum arc discharge.

More specifically, at first, an intermediate layer was formed on the above-mentioned substrate 16, and then a multilayer portion was formed in the following manner.

Referring to Fig. 12, the vacuum chamber 11 was evacuated into a vacuum condition (pressure: 1.3332 x 10⁻³ Pa (10⁻⁵ Torr)), and then Ar (argon) gas was introduced into the vacuum chamber 11 so as to provide a pressure of 1.3332 Pa (10⁻² Torr). While such a pressure of 1.3332 Pa (10⁻² Torr) was maintained, the base material 16 was heated to 500 °C and a voltage of -1000 V was applied to the base material 16 to clean the surface of the base material 16, and thereafter the Ar gas was exhausted. Then, the target 14a (Ti) and the target 14b (Al) were evaporated or ionized by use of vacuum arc discharge, while N₂ gas, CH₄ gas, or (N₂ + CH₄) gas was introduced into the vacuum chamber 11 at a rate of 200 cc/min., in a time-controlled manner in accordance with the rotation of the base material 16. When the (N₂ + CH₄) gas was used, the ratio between the flow rates of these gases was changed in accordance with a desired N/C ratio.

The thickness and/or composition of the respective layers (compound layer and composition-modulated layer) could be controlled by regulating the degree of the "overlapping" between the plasmas based on the respective targets. The degree of the "overlapping" of the plasmas could be controlled by using the location of the respective targets, arc current, and/or the pressure at the time of the film formation.

As a result of the above-mentioned arc-type ion plating method, there was formed a periodic multilayer structure comprising: a compound layer (TiN) → a composition-modulated layer (Tiₓ, Al₁₋ₓ)N → a compound layer (AlN) → a composition-modulated layer (Tiₓ, Al₁₋ ₓ)N → a compound layer (TiN) → ·····.

Prior to the above formation of the multilayer portion, the intermediate layer was formed in the following manner.

Thus, at the time of the formation of the intermediate layer, the intermediate layer having a predetermined thickness was formed in the same manner as in the formation of the multilayer material as described above except that only two targets 14a (Ti) were used in stead of using the above two targets 14a (Ti) and two targets 14b (Al) in combination, and that N₂ gas was used as the reactant gas.

Further, in a case where a surface layer was formed after the formation of the above multilayer material, the surface layer having a predetermined thickness was formed in the same manner as in the formation of the multilayer material as described above except that only the two targets 14a (Ti) were used in stead of using the above two targets 14a (Ti) and two targets 14b (Al) in combination, and that (N₂ + CH₄) gas was used as the reactant gas.

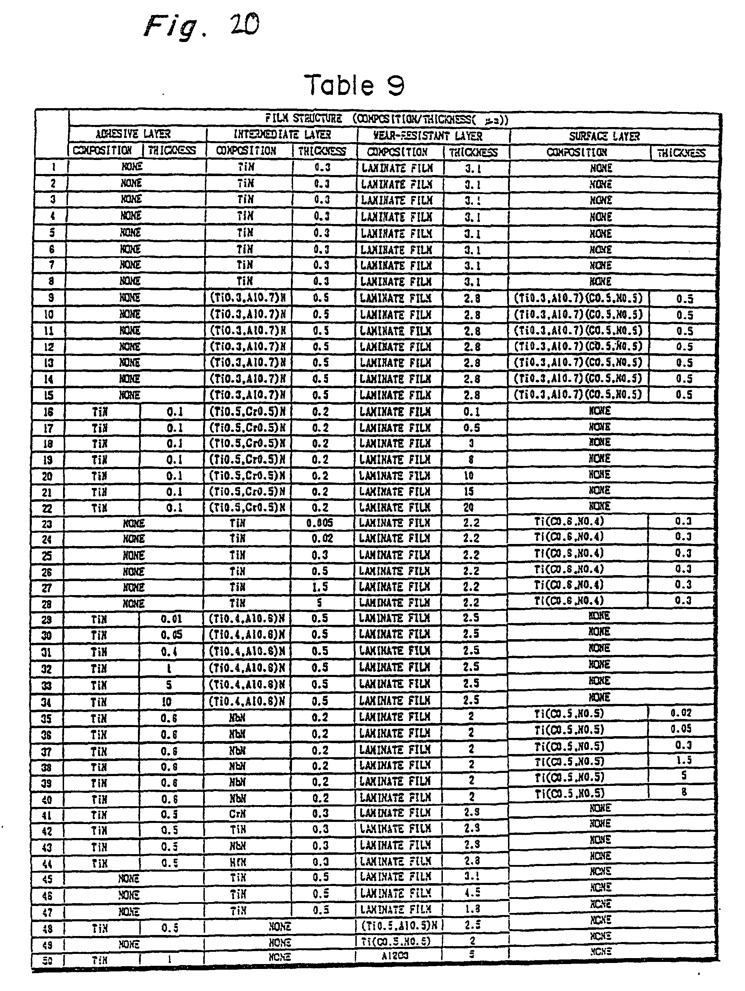

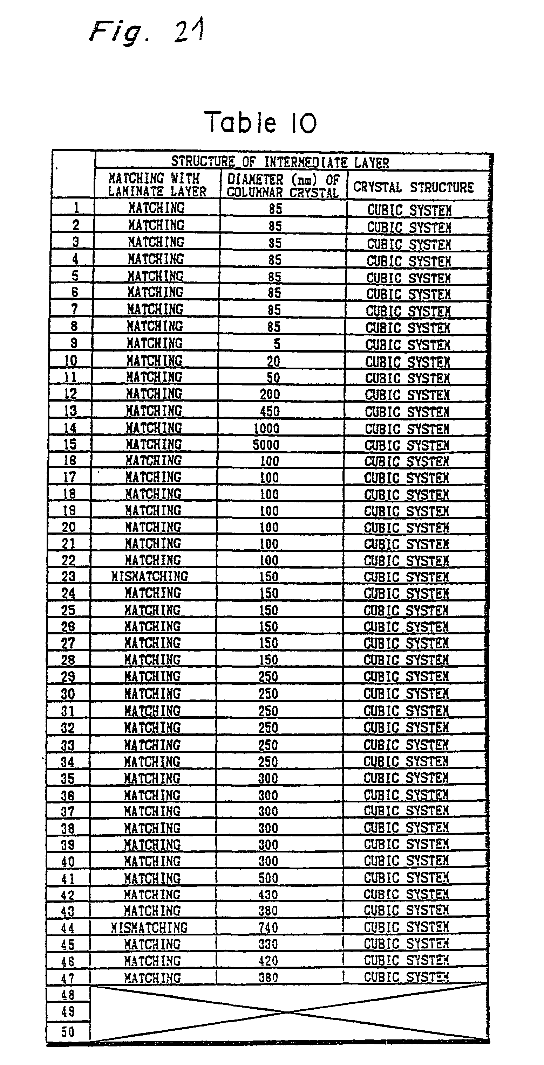

Fig. 20 (Table 9) shows the structures of the multilayer materials comprising a periodic multilayer structure (wear-resistant layer) according to the present invention (Sample Nos. 1 to 8) formed by the above procedure. Fig. 21 (Table 10) shows the structures of the intermediate layer, Fig. 22 (Table 11) shows the structures of the periodic multilayer structure (multilayer portion), and Fig. 23 (Table 12) shows the crystal structures of the multilayer portions.

The other Samples shown in the Tables 9 to 12 were prepared in the same manner as in the preparation of the above Samples (Sample Nos. 1 to 8) except that predetermined conditions were changed in the following manner.

Sample Nos. 9-15: Apparatus as shown in Fig. 11 was used. Composition (atomic percentage, atm%) of target 14a was Ti-Al (Ti/Al = 3/7), and composition of target 14b was Ti-Al (Ti/Al = 1/9).

Intermediate layer: Two targets 14a of Ti-Al (Ti/Al = 3/7) were used.

Multilayer portion: All of the targets were used.

Surface layer: Two targets 14a of Ti-Al (Ti/Al = 3/7) were used. Gas was CH₄/N₂ = 2/1.

Sample Nos. 16-22: Apparatus as shown in Fig. 13 was used. Target 14a: Ti, target 14d: Cr, targets 14e and 14f: Ti-Cr (Ti/Cr = 1/1)

Adhesion layer: Target 14c: Ti was used.

Intermediate layer: Targets 14e and 14f: Ti-Cr were used.

Multilayer portion: Target 14c: Ti, and target 14d: Cr were used.

Sample Nos. 23-28: Apparatus as shown in Fig. 11 was used. Target 14a: Ti, and target 14b: Zr were used.

Intermediate layer: Target 14a: Ti was used.

Multilayer portion: Target 14a: Ti, and target 14b: Zr were used.

Surface layer: Target 14a: Ti was used. Gas was C₂H₂/N₂ = 3/2.

Sample Nos. 29-34: Apparatus as shown in Fig. 11 was used. Target 14a: Ti, and target 14b: Al

Adhesion layer: Target 14c: Ti was used.

Intermediate layer: Target 14a: Ti and target 14b: Al were used. The rotation speed of the table was regulated so as to provide an estimated (calculated) period of 0.2 nm. Arc current was regulated so as to provide a predetermined composition ratio. As a result, a multilayer structure was not provided, but a homogeneous solid solution having a composition of (Ti 0.4, Al 0.6)N.

Multilayer portion: Target 14a: Ti, and target 14b: Al were used.

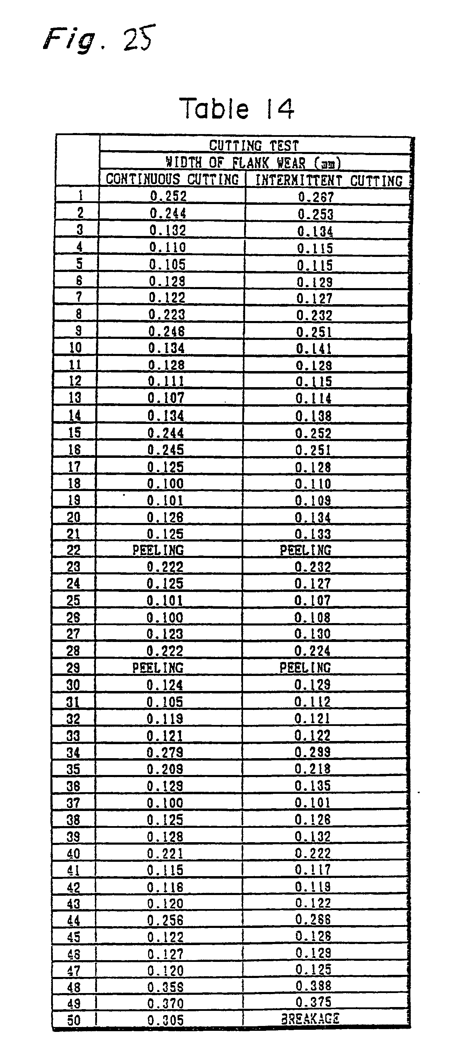

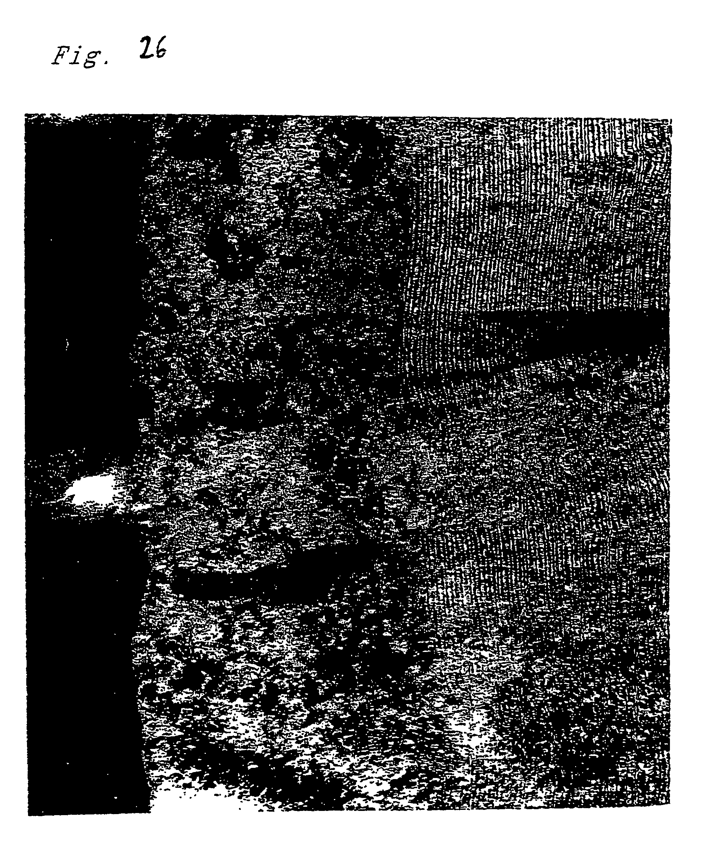

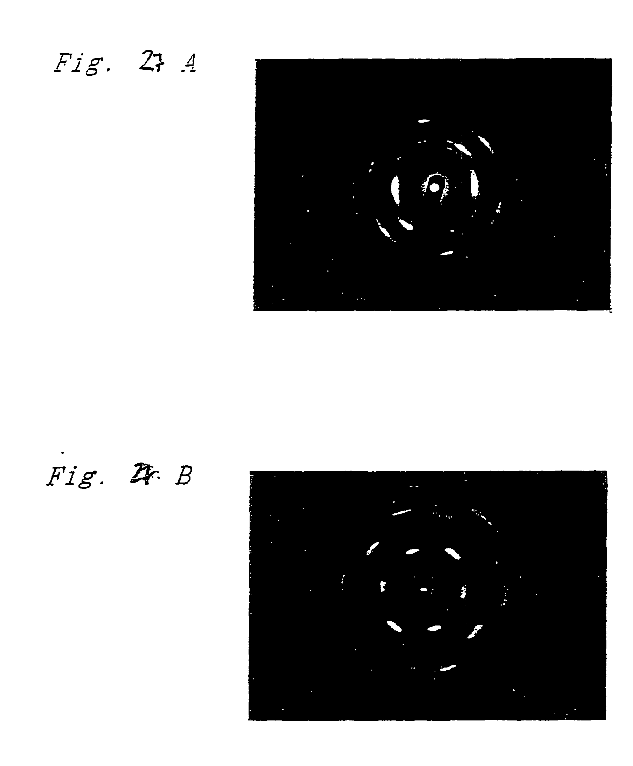

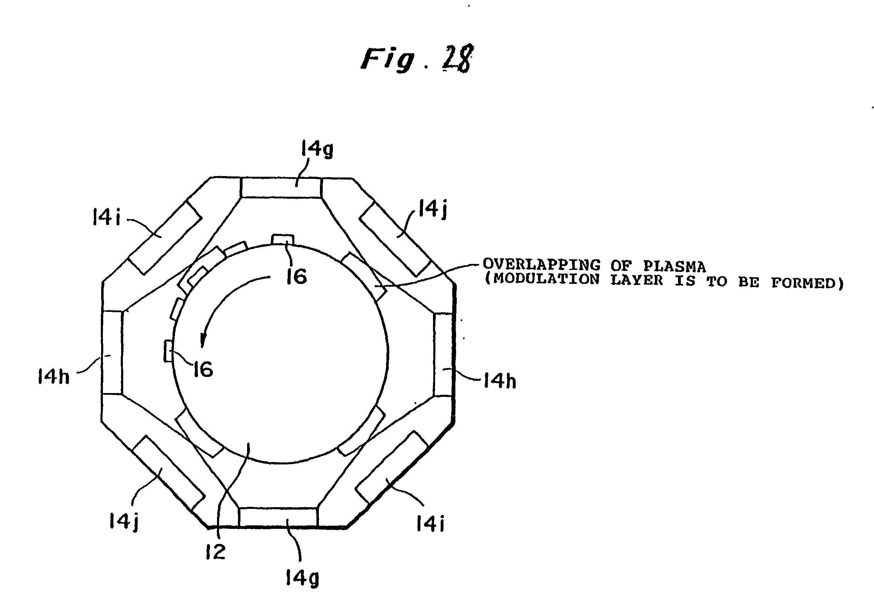

Sample Nos. 35-40: Apparatus as shown in Fig. 28 was used. Target 14g: Ti-Al (Ti/Al = 4/1), target 14h: Hf, target 14i: Ti, and target 14j: Nb were used.

Adhesion layer: Target 14i: Ti was used.

Intermediate layer: Target 14j: Nb was used.

Multilayer portion: Target 14g: Ti-Al, and target 14h: Hf were used.

Surface layer: Target 14i: Ti was used. Gas was C₂H₂/N₂ = 1/1.

Sample Nos. 41-44: Apparatus as shown in Fig. 13 was used. Target 14c: Ti-Al (Ti/Al = 3/7), target 14d: Al, and target 14e: Ti were used.

Target 14f: Cr (Sample No.41), Ti (Sample No.42), Nb (Sample No.43), Hf (Sample No.44),

Adhesion layer: Target 14e: Ti was used.

Intermediate layer: Each of the above target 14f was used.

Multilayer portion: Target 14c: Ti-Al, and target 14d: Al were used.

Sample No. 45: Apparatus as shown in Fig. 13 was used. Targets 14c, 14e and 14f: Ti, and target 14d: TiC wee used.

Intermediate layer: Targets 14e and 14f: Ti were used.

Multilayer portion: Target 14c: Ti, and target 14d: TiC were used. The film formed in N₂ gas by use of a TiC target had a composition of Ti(C 0.6, N 0.4).

Sample No. 46: Apparatus as shown in Fig. 11 was used. Target 14a: Ti, 14b: Ti-Hf (Ti/Hf = 1/1)

Intermediate layer: Targets 14a: Ti was used.

Multilayer portion: Target 14a: Ti, and target 14b: Ti-Hf were used. Gas was C₂H₂/N₂ = 1/1.

Sample No. 47: Apparatus as shown in Fig. 28 was used. Target 14g: Ti-Zr (Ti/Zr = 7/3), target 14h: Ti-Hf (Ti/Hf = 3/7), target 14i: Ti

Intermediate layer: Target 14i: Ti was used.

Multilayer portion: Target 14g: Ti-Zr, and target 14h: Ti-Hf were used.

### Comparative Example 1

Sample No. 48 was prepared in the same manner as in the Example, except that an adhesion layer of TiN was formed, a target 14a of Ti and a target 14b of Ti-Al were used, an intermediate layer was formed by using the target 14a, a TiAlN portion was formed by using the target 14b (N₂ gas was used in combination), and an arc-type ion plating method was used.

### Comparative Example 2

Sample No. 49 was prepared by using a known ion plating method.

### Comparative Example 3

Sample No. 50 was prepared by using a known CVD method.

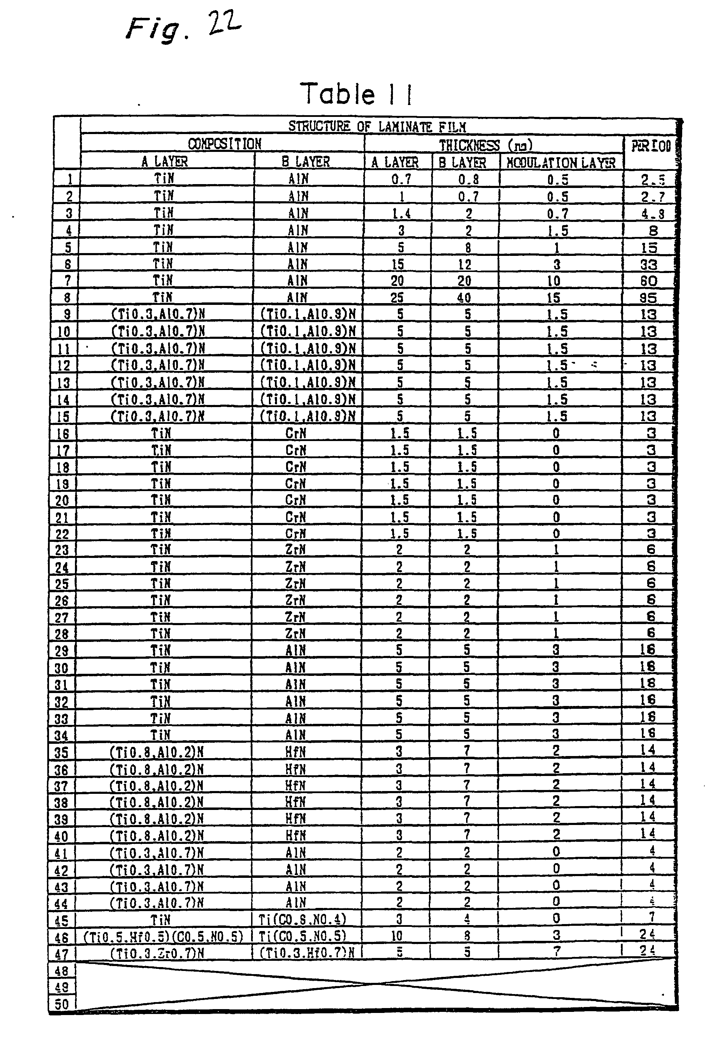

The surface-coated cutting tip samples (Sample No. 1 to 50 shown in the above Table 9) which had been prepared in the above Example and Comparative Examples 1-3 were subjected to continuous cutting tests and intermittent cutting tests under the conditions as shown in Fig. 24 (Table 13), thereby to measure the width or degree (mm) of flank wear of the edge thereof. Fig. 25 (Table 14) shows the results of evaluation of performances of the multilayer materials.

As shown in the above Fig. 25 (Table 14), it was found that the cutting tip Samples coated with the multilayer material as a surface coating layer according to the present invention had an excellent wear resistance under both of continuous cutting and intermittent cutting. In other words, it was found that the cutting performances and the life of the cutting tools were remarkably improved when the multilayer material according to the present invention was used as the surface coating material of the hard member constituting the cutting tool.

### (Measurement of compositional change profile)

Referring to Fig. 12, a film was formed on the base material 16 for 10 min. under the same conditions (gas pressure, arc current, bias voltage) as in the preparation of Sample No. 4 in the above Table 9, except that the substrate holder 12 was not rotated. At this time, 33 plates of the substrates 15 were disposed so as to provide equal intervals therebetween, at positions from that disposed in front of the Ti target 14a (No. 1), via that disposed in front of the next Al target (No. 17), to that disposed in front of the next Ti target 14a (No. 33).

The film thicknesses of the resultant films formed on the respective substrates 16 placed at the respective positions along the circumferential direction of the substrate holder 12 were measured by means of a SEM (scanning electron microscope), and the compositions (Ti/Al ratio) of the respective films were measured by means of an EDX attached to the SEM. In this Example, it was estimated that the thus obtained compositions and the film thicknesses of the substrates disposed at the respective positions corresponded to the compositions and film forming rates for the films to be formed in the vacuum chamber 11. Fig. 14 is a graph showing the thus obtained data of the composition ratio, and Fig 15 is a graph showing the thus obtained data of the film thickness.

In above EDX analysis, the following conditions were employed.

### <EDX analysis condition>

### SEM the main body

Measurement apparatus: trade name: JSM 6300-F mfd. by Nihon Denshi (JEOL) K.K.

### Attachment EDX apparatus

trade name: EXL, mfd. by LINK Co. (at present, Oxford Co.)
Detector: Si (Li) semiconductor detector

### Measurement conditions

Accelerating voltage: 15 eV
Irradiation current: 0.3 nA
Open type (protective window for the detector was left open.)

When the thus obtained composition data of the films disposed on each of the base materials were plotted as an ordinate, and a series of the cumulative film thickness (i.e., a sequence of total thicknesses obtained by successively adding thicknesses of the respective films) were plotted as an abscissa, there was obtained a graph of Fig. 16 (compositional change profile). At this time, two targets were disposed for each of the respective kinds thereof in the vacuum chamber as shown in Fig. 12, and therefore the compositional change profile with two periods was obtained corresponding to one rotation of the substrate holder. In this Figure, one period of the multilayer film corresponds to 0.5 period of the compositional change profile shown in Fig. 16. In other words, when a multilayer film having a period of 20 nm is formed, the entirety of the abscissa the graph of Fig. 23 corresponds to 10 nm.

Based on the data shown in the above Fig. 16, there was obtained a compositional change profile of the entire multilayer film as shown in the graph of Fig. 24. On the basis of the thus obtained compositional change profile shown in the graph of Fig. 17, it should be understood that the multilayer material having a composition-modulated layer according to the present invention does not have an interface (i.e., a boundary at which the composition is discontinuous).

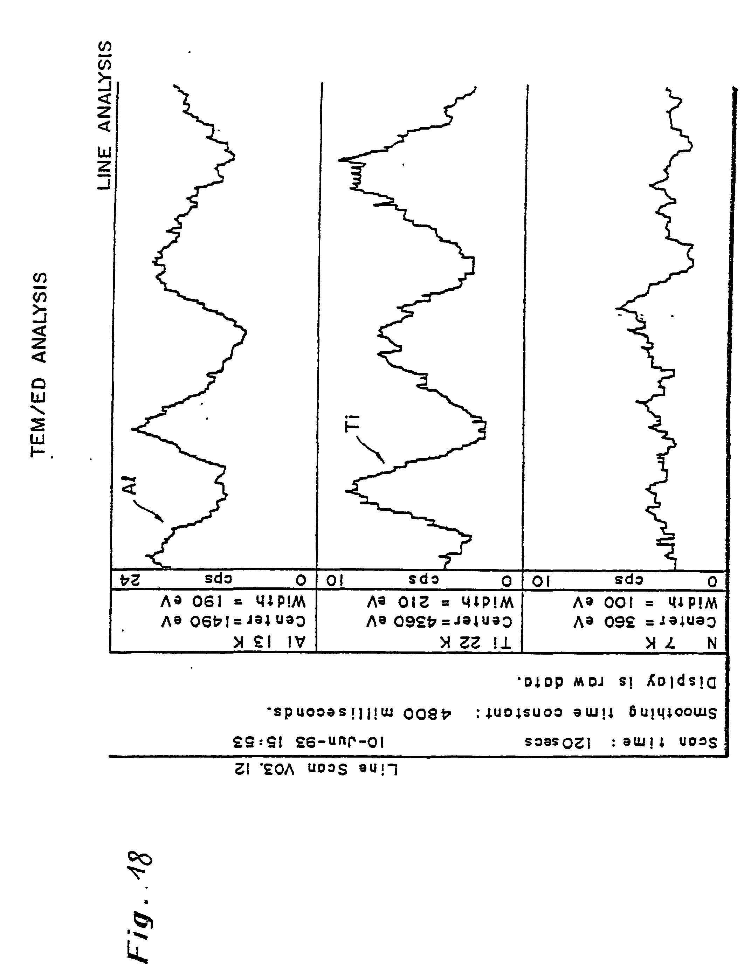

Fig. 18 shows an example of EDX data which were obtained by measuring the entire multilayer film. In this graph, the graph at the upper stage represents an Al distribution, the graph at the middle stage represents a Ti distribution, and the graph at the lower stage represents an N distribution. The data of this Fig. 18 are those obtained by analyzing a multilayer material in the form of a thin flake having a thickness of about 10 µm by means of an EDX attached to a TEM. At this time, the resolving power of the TEM/EDX is about 1 nm which is substantially at the same level of the film thickness of each of the respective layers (compound layer, composition-modulated layer) constituting the multilayer film. Accordingly, the resolving power in the data of Fig. 18 has a certain limit.
Measurement apparatus: HB-501 mfd. by VG Co.
EDX: KEVEX Super8000, Total System for Quantitative Analysis
Energy dispersive x-ray analyzer:
   (Si <Li>semiconductor detector, UTW-type)
EELS: ELS-80 Spectrometer mfd. by VG Co.
   (energy resolution: 0.56 eV)

### (TEM observation of multilayer film)

Sample No. 3 as shown in the above Table 9 was subjected to ion etching to be formed into a thin flake, and the resultant thin flake was observed by means of a TEM (trade name: H-900UHR, mfd. by Hitachi Seisakusho K.K.). The resultant image is shown in Fig. 39 (magnification: 20 x 10⁴, a length of 2 cm in the image is equivalent to 100 nm.

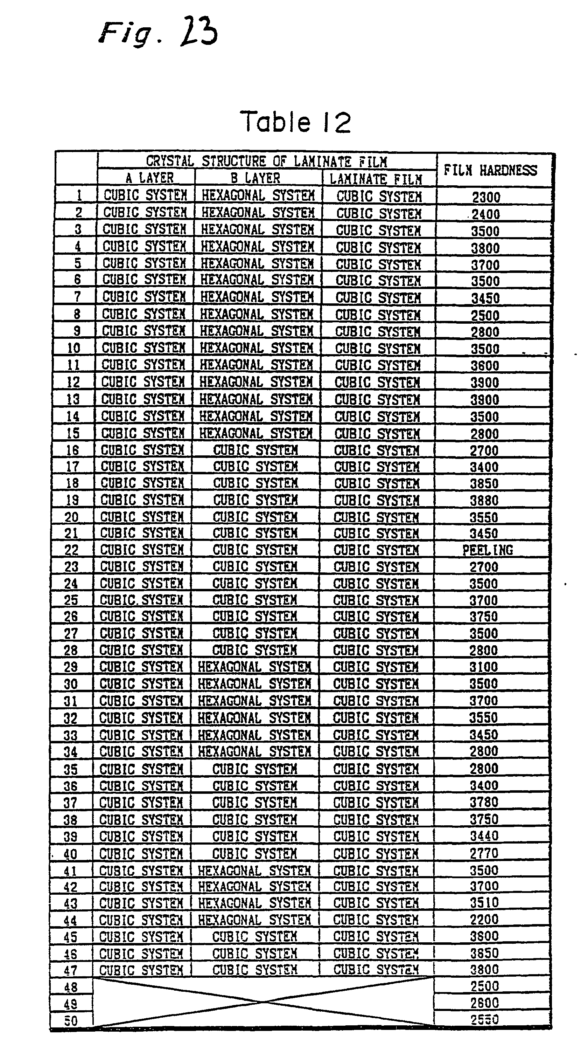

In Fig. 26, the darkest portion (on the left side of the Figure) represents the base material, the multilayer structure on the right side of the Figure represents a wear-resistant multilayer portion (wherein the relatively bright portion in the contrast is a TiN layer, and the relatively dark potion is an AlN layer. Further, the layer located between the base material and the multilayer portion is an intermediate layer. In the intermediate layer, the presence of columnar crystals is recognized, and the orientation of the multilayer portion matching with the columnar crvstals (i.e., a portion which has been grown so as to continuously match with the columnar crystals) is recognized.

### (Analysis of crystal structure by TED)

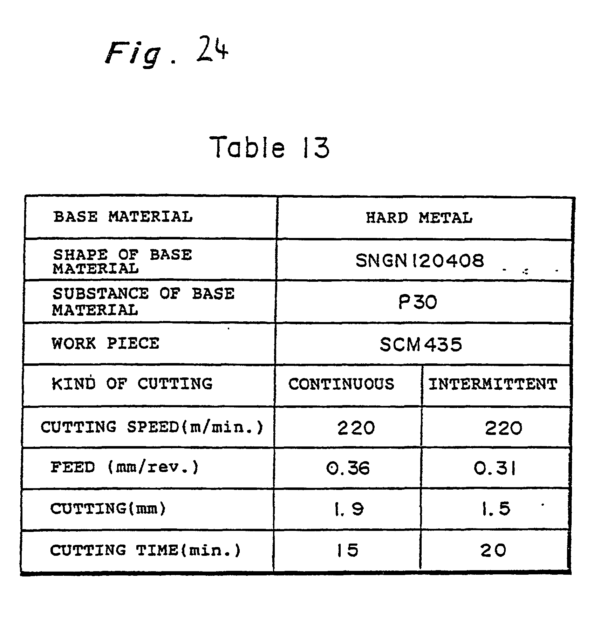

Sample No. 3 in the above Table 9 was analyzed by means of a TED (trade name: H-900UHR, mfd. by Hitachi Seisakusho K.K.). The resultant diffraction pattern is shown in Fig. 27, wherein the pattern "A" represents a pattern of the surface side of the Sample, and the pattern "B" represents a pattern of the substrate side thereof. Based on the above diffraction pattern it was confirmed that the entire multilayer film had a crystal structure of NaCl-type (cubic crystal system).

In this diffraction pattern, satellite patterns are recognizable around left and right spots and the center spot. According to the present inventors' knowledge, these patterns are those corresponding to a periodic multilayer structure.

When the multilayer material according to the present invention is used as a coating layer, the wear resistance, heat resistance, and/or corrosion resistance of a part or component such as cutting tool, wear-resistant tool, electric or electronic component, sliding part, and machine part, may remarkably be improved.

When the multilayer material according to the present invention is used as a surface coating material for various tools such as cutting tool (tip, drill, end mill, etc.) and wear-resistant tool, the cutting performance or life of these cutting tools, etc., may remarkably be improved.

Further, when the multilayer material according to the present invention is used as a wear-resistant film or protective film for an electric or electronic component, and a sliding or machine component, an excellent wear resistance may also be obtained in a similar manner as in the case of the above cutting tool, etc.

## Claims

1. A multilayer material comprising a base material which comprises a WC-based hard material, and a multilayer portion which comprises:
two kinds of compound layers of TiN and AlN;
a composition-modulated layer disposed between the compound layers, and having a composition such that the composition ratio (at%) of an element is changed;
the compound layer and the composition-modulated layer being periodically stacked;
the multilayer material further comprising an intermediate layer disposed on the base material side of the multilayer portion, the intermediate layer comprising (Ti0.4,Al0.6)N;
the intermediate layer, and at least one layer of the multilayer portion nearest to the base material side having a continuous crystal lattice; and
the multilayer material further comprising an adhesion layer which is disposed on the base material side surface of the intermediate layer, the adhesion layer comprising TiN.

2. A multilayer material comprising a base material which comprises a WC-based hard material, and a multilayer portion which comprises:
two kinds of compound layers of (Ti0.8,Al0.2)N and HfN;
a composition-modulated layer disposed between the compound layers, and having a composition such that the composition ratio (at%) of an element is changed;
the compound layer and the composition-modulated layer being periodically stacked;
the multilayer material further comprising an intermediate layer disposed on the base material side of the multilayer portion, the intermediate layer comprising NbN;
the intermediate layer, and at least one layer of the multilayer portion nearest to the base material side having a continuous crystal lattice; and
the multilayer material further comprising an adhesion layer which is disposed on the base material side surface of the intermediate layer, the adhesion layer comprising TiN.

## Patentansprüche

1. Ein mehrschichtiges Material aufweisend ein Grundmaterial, das ein WC-basiertes Hartmaterial umfasst, und einen mehrschichtigen Teil, welche folgendes umfasst:
zwei Arten von Verbundschichten aus TiN und AIN;
eine in der Zusammensetzung modulierte Schicht, die zwischen den Verbundschichten angeordnet ist und eine Zusammensetzung aufweist, so dass das Zusammensetzungsverhältnis (in %) eines Elementes verändert wird;
wobei die Verbundschicht und die in der Zusammensetzung modulierte Schicht periodisch aufeinander geschichtet sind;
wobei das mehrschichtige Material weiter eine Zwischenschicht umfasst, die auf der Seite des Grundmaterials des mehrschichtigen Teils angeordnet ist, wobei die Zwischenschicht (Ti0.4,A10.6)N umfasst;
wobei die Zwischenschicht und wenigstens eine Schicht des mehrschichtigen Teils, die der Seite des Grundmaterials am nächsten liegt, ein kontinuierliches Kristallgitter aufweisen; und
wobei das mehrschichtige Material weiter eine Adhäsionsschicht aufweist, die auf der Oberfläche der Zwischenschicht auf der Grundmaterialseite angeordnet ist, wobei die Adhäsionsschicht TiN aufweist.

2. Ein mehrschichtiges Material aufweisend ein Grundmaterial, das ein WC-basiertes Hartmaterial umfasst, und einen mehrschichtigen Teil, welche folgendes umfasst:
zwei Arten von Verbundschichten aus (Ti0.8,A10.2)N und HfN;
eine in der Zusammensetzung modulierte Schicht, die zwischen den Verbundschichten angeordnet ist und eine Zusammensetzung aufweist, so dass das Zusammensetzungsverhältnis (in %) eines Elementes verändert wird;
wobei die Verbundschicht und die in der Zusammensetzung modulierte Schicht periodisch aufeinander geschichtet sind;
wobei das mehrschichtige Material weiter eine Zwischenschicht umfasst, die auf der Seite des Grundmaterials des mehrschichtigen Teils angeordnet ist, wobei die Zwischenschicht NbN umfasst;
wobei die Zwischenschicht und wenigstens eine Schicht des mehrschichtigen Teils, die der Seite des Grundmaterials am nächsten liegt, ein kontinuierliches Kristallgitter aufweisen; und
wobei das mehrschichtige Material weiter eine Adhäsionsschicht aufweist, die auf der Oberfläche der Zwischenschicht auf der Grundmaterialseite angeordnet ist, wobei die Adhäsionsschicht TiN aufweist.

## Revendications

1. Matériau multicouche comprenant un matériau de base qui comporte un matériau dur à base de WC, une partie multicouche qui comprend :
deux sortes de couches de composés TiN et AlN,
une couche à composition modulée disposée entre les couches de composés et ayant une composition telle que le rapport de composition (% atomique) d'un élément varie,
la couche de composés et la couche à composition modulée étant empilées périodiquement,
le matériau multicouche comprenant en outre une couche intermédiaire disposée du côté du matériau de base de la partie multicouche, la couche intermédiaire comprenant (Ti_{0,4},Al_{0,6})N,
la couche intermédiaire et au moins une couche de la partie multicouche la plus proche du côté du matériau de base ayant un réseau cristallin continu, et
le matériau multicouche comprenant en outre une couche d'adhérence qui est disposée à la surface du côté du matériau de base de la couche intermédiaire, la couche d'adhérence contenant TiN.

2. Matériau multicouche comprenant un matériau de base qui comprend un matériau dur à base de WC, et une partie multicouche qui comprend :
deux sortes de couches de composés (Ti_{0,8},Al_{0,2})N et HfN,
une couche à composition modulée disposée entre les couches de composés et ayant une composition telle que le rapport de composition (% atomique) d'un élément varie,
la couche de composés et la couche à composition modulée étant empilées périodiquement,
le matériau multicouche comprenant en outre une couche intermédiaire disposée du côté du matériau de base de la partie multicouche, la couche intermédiaire comprenant NbN,
la couche intermédiaire et au moins une couche de la partie multicouche la plus proche du côté du matériau de base ayant un réseau cristallin continu, et
le matériau multicouche comprenant en outre une couche d'adhérence qui est disposée à la surface du côté du matériau de base de la couche intermédiaire, la couche d'adhérence contenant TiN.
